(19) Europäisches Patentamt
European Patent Office
Office européen des brevets

(11) **EP 1 560 272 B1**

(12) **EUROPEAN PATENT SPECIFICATION**

(45) Date of publication and mention
of the grant of the patent:
**27.04.2016 Bulletin 2016/17**

(51) Int Cl.:
*H01L 31/0224* (2006.01)   *H01L 27/142* (2006.01)
*H01L 31/05* (2006.01)

(21) Application number: **05001715.1**

(22) Date of filing: **27.01.2005**

(54) **Solar cell module**

Solarzellenmodul

Module de cellules solaires

(84) Designated Contracting States:
**DE ES FR IT**

(30) Priority: **29.01.2004 JP 2004021387**
**23.03.2004 JP 2004085185**

(43) Date of publication of application:
**03.08.2005 Bulletin 2005/31**

(73) Proprietor: **Panasonic Intellectual Property
Management Co., Ltd.
Osaka-shi, Osaka 540-6207 (JP)**

(72) Inventors:
• **Yoshimine, Yukihiro
Kobe-shi,
Hyogo 651-2227 (JP)**

• **Ninomiya, Kunimoto
Hirakata-shi,
Osaka 573-1155 (JP)**

(74) Representative: **Glawe, Delfs, Moll
Partnerschaft mbB von
Patent- und Rechtsanwälten
Postfach 26 01 62
80058 München (DE)**

(56) References cited:
**EP-A- 0 710 990    EP-A- 1 172 864
US-A- 5 637 156    US-A1- 2002 016 016**

**Description**

BACKGROUND OF THE INVENTION

Field of the Invention

The present invention relates to a solar cell module, and more particularly, to a technique to improve the yield of a solar cell module.

Description of the Related Art

Solar cells are being expected to be a new energy source that can convert light from the sun, which is a clean inexhaustible energy source, directly into electricity.

Because a single solar cell outputs as small as a few watts, generally a plurality of solar cells are electrically connected in series or parallel to enhance the output to a few hundreds watts and used as a solar cell module to power houses and buildings.

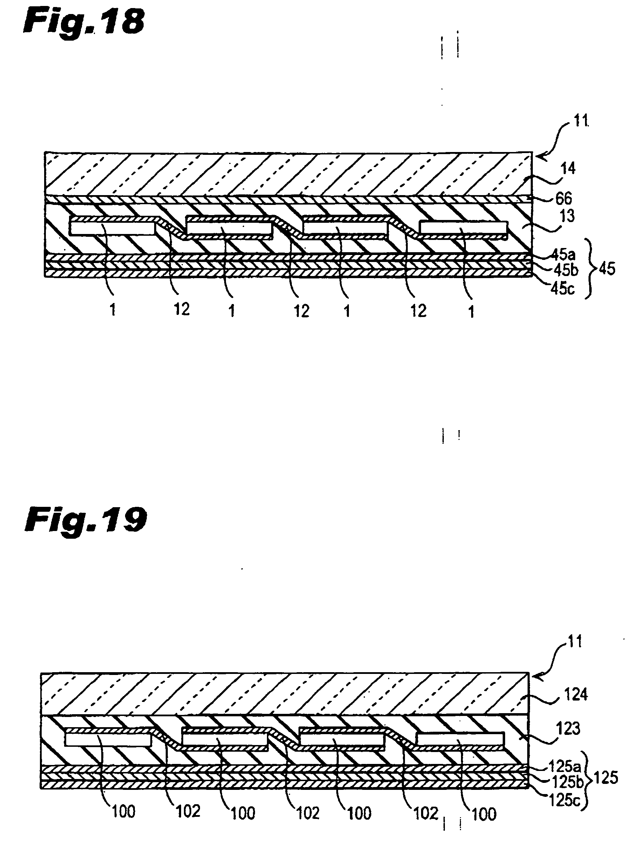

FIG. 19 is a cross-sectional view partially showing the structure of a conventional solar cell module. As shown in FIG. 19, a plurality of solar cell elements 100 are electrically connected with tabs 102 comprised of an electrically-conductive material such as copper foil. The solar cell elements 100 are sealed with a light-transmitting sealant 123 such as ERA (Ethylene Vinyl Acetate) between a light-transmitting front surface member 124 such as glass and light-transmitting plastic and a rear surface protective member 125 having a three-layer structure of a PET (Polyethylene Terephthalate) layer 125a / aluminum (Al) foil 125b / a PET layer 125c.

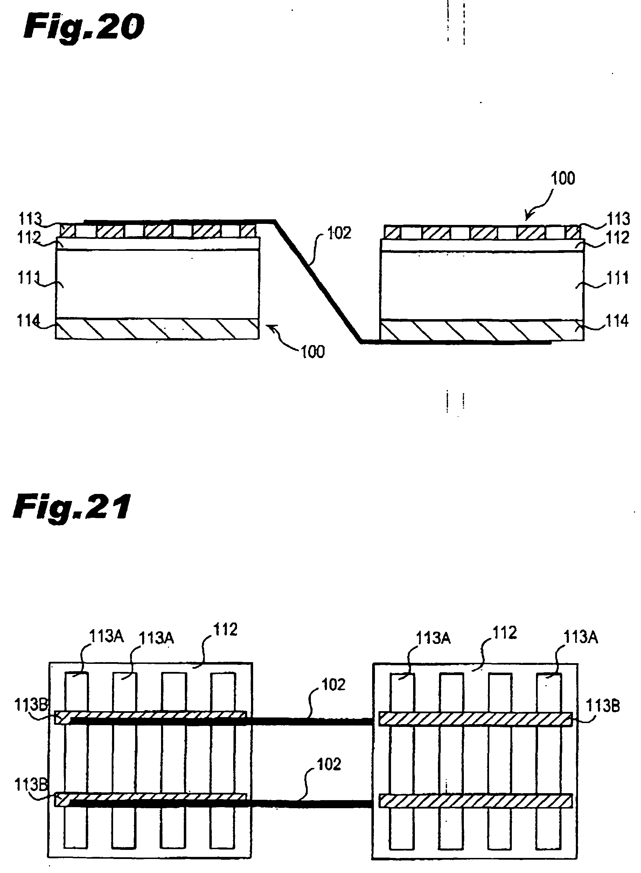

FIGs. 20 and 21 are a cross sectional view and a plan view respectively, showing one example of solar cell elements having a collector electrode used in the above mentioned solar cell module.

As shown in FIGs. 20 and 21, the exemplary solar cell element 100 is provided with a single crystal silicon substrate 111 having p-type conductivity. An n layer 112 is formed to about 5 $\mu$m in depth on a surface of the substrate 111 by diffusing n-type impurities in a thermal diffusion process. On the n layer 112 formed is a comb-shaped collector electrode 113. A rear surface electrode 114, which is a counterpart of the collector electrode 113, is formed on a rear surface of the substrate 111.

Referring to FIG. 20, there are shown that the collector electrode 113 is comprised of finger portions 113A and bus bar portions 113B. The finger portions 113A collects photo carriers of electrons and holes generated in the substrate 111 with incident light. The bus bar portions 113B receives the carriers collected by the finger portions 113A.

The collector electrode 113 is desired to be as small as possible because the collector electrode 113 blocks light incident into the solar cell element 100 and may cause to reduce the effective area of the solar cell element 100. For this reason, the finger portion 113A is generally assumed to have a width of about 100 $\mu$m and to be spaced about 2 mm apart from adjacent finger portions. The bus bar portions 113B need to reduce some degree of their resistance components in order to receive the carriers collected by finger portions 113A, therefore, the width of a bus bar portion 113B is set about 1.5 mm, which is wider than the width of the finger portion 113A. The collector electrode 113 having the finger portions 113A and the bus bar portions 113B is formed so as to have a thickness of about 40 $\mu$m by screen printing.

As shown in FIGs. 20 and 21, the adjacent solar cell elements 100 and 100 are electrically connected by connecting the bus bar portions 113B of the collector electrode 113 of one solar cell element 100 and the rear surface electrode 114 of another solar cell element 100 with connecting tabs 102.

The plurality of solar cell elements 100, which are electrically connected to each other by the connecting tabs 102, are sandwiched between the front surface member 124 and the rear surface protective member 125 with sealant interposed. The solar cells are then heated under reduced pressure to be integrated. In this way, a solar cell module is completed.

By the way, attention is being giving to a solar cell element in which a substantially intrinsic amorphous silicon layer is sandwiched between a single crystal silicon substrate and an amorphous silicon layer, which is so called an HIT (Hetero-junction with Intrinsic Thin layer) structure. With the structure, defects at interfaces with the intrinsic amorphous silicon layer are reduced, thereby improving the property of the hetero junction interfaces. Even such a solar cell element with the HIT structure is provided with a collector electrode comprising finger portions and bus bar portions. In the HIT solar cell element, silver paste containing curing resin is also used as a material of the collector electrode, in consideration of the amorphous silicon layer positioned under the collector electrode. In the same manner as the single crystal type solar cell, the collector electrode comprising the finger portions (thin lines for collecting current) and bus bar portions (heavy lines) is formed with the silver paste. The bus bar portions are required to have good compatibility with solder of the connecting tab, which is made of solder-coated copper foil, in addition to a high degree of adhesion with an underlaid transparent electrode (e.g. ITO (Indium Tin Oxide) electrode).

The curing resin contained in the silver paste may be epoxy resin, urethane resin, silicone resin, polyimide resin or phenolic resin. The compound ratio of the resin is determined depending on specific resistance of the paste, adhesion with an underlayer, and compatibility with solder. In order to reduce the specific resistance, generally a mixture of epoxy resin and urethane resin is often used.

In a case of using well-known lead (Pb)-containing solder, so-called eutectic solder, it is possible to solder the bus bar portions, even if the mixture used for the bus bar portions contains epoxy resin and urethane resin in equal proportions by volume.

In consideration of influence on natural environment, however, it is preferable to use lead (Pb) free solder.

The use of lead (Pb) free solder with consideration given to influence on natural environment raises problems such as a rise in melting point and reduction in adhesion. If lead (Pb) free solder with a high melting point is used, soldering temperature should be increased. For example, Sn-Ag-Cu based lead (Pb)-free solder has relatively good adhesion, but its melting point is 218°C, which is higher than the eutectic solder's melting point of 183°C.

If such solder is used to solder the typical collector electrode composed of silver paste, the urethane resin is pyrolyzed and the pyrolyzed resin makes the silver paste brittle. As a result, adhesion between a connecting tab and a solar cell element will be decreased.

This decreased adhesion causes failures including removal of the tab in a process after soldering. In addition, when a module is fabricated with such brittle silver paste, with a decrease in moisture resistance of the collector electrode (silver paste), moisture resistance of the module is also decreased.

When using the single crystal silicon in the solar cell element shown in FIGs. 20 and 21, heat-curing type paste can be used as the silver paste; therefore, connection can be made with soldering temperature remained high. Thus there is no apprehension of rising problems as described above.

When the above-mentioned three-layer structure with Al foil sandwiched is used as a rear surface protective member of the solar cell module, it is possible to prevent water permeation since the Al foil has a very low water vapor transmission rate and hardly allows water to permeate therethrough. However, fabricating a solar cell module with a rear surface protective member not including metal materials such as Al foil is another option. In this case, a lot of water permeates into the conductive paste forming the collector electrodes with an increase in water vapor transmission rate of the rear surface protective member. Thus resin contained in the conductive paste is hydrolyzed, thereby increasing contact resistance of the collector electrodes. As a result, the output of the solar cell module is reduced. Therefore, the three-layer structure solar cell module without Al foil has a problem of moisture resistance, that is the reduction of output maintenance against water vapor.

SUMMARY OF THE INVENTION

The present invention has been made to solve the above described problems and has an object to improve adhesion property between connection tabs comprising lead (Pb) free solder and collector electrodes comprising electrically-conductive paste containing curing resin in a solar cell element.
The present invention has another object to provide a solar cell module for preventing yield reduction by controlling moisture resistance reduction.

In a solar cell module in which a plurality of solar cell elements are placed between a front surface member and a rear surface protective member and collector electrodes of the solar cell elements are electrically connected to each other via connecting tabs, the present invention is characterized in that the collector electrodes of the solar cell elements are made of electrically-conductive paste containing thermosetting resin and electrically-conductive powder, the thermosetting resin consisting of epoxy resin and urethane resin and containing 70% and 90% by volume epoxy resin having a glass transition temperature of 80°C to 200 °C measured by a TMA method, and the connecting tabs are soldered to the electrodes with Sn-Ag-Cu solder.

By using the conductive paste containing electrically-conductive power and thermosetting resin that includes 70% - 90% epoxy resing by volume having a glass transition temperature of 80°C to 200°C measured by the TMA method, even if connecting tabs coated with lead (Pb) free Sn-Ag-Cu solder are used, adhesion between the solar cell element and the connecting tabs is improved, thereby being possible to reduce incidence of defects in a post-process. Especially, containing 70% - 90% epoxy resin by volume, which has a glass transition temperature of 80°C to 200 °C measured by the TMA method, in the thermosetting resin makes it possible to substantially reduce the incidence of defects and to improve the moisture resistance of the module.

The electrically-conductive powder to be mixed in the conductive paste includes approximately granulated electrically-conductive filler and flaky electrically-conductive filler. It is preferable to contain 40 wt.% to 80 wt.% approximately granulated conductive filler to total weight of both conductive fillers.

If the content of the approximately granulated conductive filler to total weight of both conductive fillers is 40 wt.% to 80 wt.%, incomplete print will not occur. Therefore electrically-conductive paste having appropriate specific resistance can be obtained for solar cells.

The above described structure can prevent an increase in contact resistance between the electrode and the surface of the solar cell element on which the electrode is formed, even if the electrode is deteriorated, thereby preventing output-characteristics reduction of the solar cell module caused by water. As a result it can be said that the moisture resistance of the solar cell module is prevented from being reduced. In the above described structure, since it is not necessary to use metal material such as Al foil to form the rear surface protective layer with the aim of lowering the water vapor transmission rate of the rear surface protective member, withstand voltage between solder for connecting the connecting tab to the solar cell element and the rear surface protective member is not reduced when the connecting tabs are used to connect the plurality of solar cell elements to each other to form the solar cell module. Therefore insulation failure can be suppressed to occur, thereby preventing yield reduction of the solar cell module.

In the above solar cell module, the water vapor transmission rate of the rear surface protective member is preferably 15 $g/m^2 \cdot 24hrs$ (40 °C, 90%) or less and the percentage of epoxy content in the thermosetting resin is 90 vol.%. In the case where the water vapor transmission rate of the rear surface protective member is 15 $g/m^2 \cdot 24hrs$ (40°C, 90%) or less and the thermosetting resin contains 90 vol.%
epoxy resin, it is possible to easily prevent the electrodes from being deteriorated resulting from hydrolyzed thermosetting resin. Therefore the moisture resistance of the solar cell module can be improved. Note that the water vapor transmission rate of 15 $g/m^2 \cdot 24hrs$ (40 °C, 90%) or less means an amount of water vapor that permeates through the rear surface protective member is 15 $g/m^2$ or less after a 24-hour water vapor transmission test conducted at a temperature of 40 °C and a humidity of 90%.

In the above solar cell module, the water vapor transmission rate of the rear surface protective member is preferably 0.1 $g/m^2 \cdot 24hrs$ (40 °C, 90%) or less and the percentage of epoxy content in the thermosetting resin is 80 vol.% - 90vol%. In the case where the water vapor transmission rate of the rear surface protective member is 0.1 $g/m^2 \cdot 24hrs$ (40 °C, 90%) or less and the thermosetting resin contains 80 vol.% - 90vol% epoxy resin, it is possible to easily prevent the electrodes from being deteriorated resulting from hydrolyzed thermosetting resin. Therefore the moisture resistance of the solar cell module can be improved. Note that the water vapor transmission rate of 0.1 $g/m^2 \cdot 24hrs$ (40 °C, 90%) or less means an amount of water vapor that permeates through the rear surface protective member is 0.1 $g/m^2$ or less after a 24-hour water vapor transmission test conducted at a temperature of 40 °C and a humidity of 90%.

In the above solar cell module, the water vapor transmission rate of the rear surface protective member is preferably 0.02 $g/m^2 \cdot 24hrs$ (40 °C, 90%) or less and the percentage of epoxy content in the thermosetting resin is 70 vol.% - 90vol%. In the case where the water vapor transmission rate of the rear surface protective member is 0.02 $g/m^2 \cdot 24hrs$ (40°C, 90%) or less and the thermosetting resin contains 70 vol.% to 90 vol% epoxy resin, it is possible to easily prevent the electrodes from being deteriorated resulting from hydrolyzed thermosetting resin. Therefore the moisture resistance of the solar cell module can be improved. Note that the water vapor transmission rate of 0.02 $g/m^2 \cdot 24hrs$ (40°C, 90%) or less means an amount of water vapor that permeates through the rear surface protective member is 0.02 $g/m^2$ or less after a 24-hour water vapor transmission test conducted at a temperature of 40°C and a humidity of 90%.

In the above solar cell module, it is preferable that the rear surface protective member includes an insulation layer made of either silicon oxide or metal oxide. The insulation layer made of either silicon oxide or metal oxide, which has a low water vapor transmission rate, contributes to reduced water vapor transmission rate of the rear surface protective member. In the case where the insulation layer is used for the rear surface protective member, insulation failure between the connecting tab and the rear surface protective member does not occur in a solar cell module in which a plurality of solar cell elements are connected to each other by connecting tabs. Therefore, the improvement of the moisture resistance can be obtained while yield reduction caused by the insulation failure can be prevented.

In the above solar cell module, it is preferable that the rear surface protective member includes resin materials but not metal materials. Accordingly, insulation failure occurring between solder for connecting the connecting tabs to the solar cell elements and the rear surface protective member is reliably prevented in a solar cell module in which a plurality of solar cell elements are connected to each other by connecting tabs.

In the above solar cell module, the front surface member contains sodium and a sodium blocking layer for preventing sodium permeation is provided between the front surface member and the solar cell element. Accordingly, even when sodium is leached out from the member containing sodium to water permeating into the solar cell module and the sodium-containing water diffuses in the solar cell module, the sodium blocking layer prevents sodium from reaching the solar cell elements. In the case of the solar cell elements including a p-type semiconductor layer, activity of p-type impurities in the p-type semiconductor is not discouraged by the sodium. As a result, output-characteristics reduction of the solar cell module is prevented.

In the above solar cell module, the front surface member contains sodium and a sodium blocking layer for preventing sodium permeation is provided on a front surface of the front surface member of the solar cell element. Accordingly, even when sodium is leached out from the member containing sodium to water permeating into the solar cell module and the water containing sodium diffuses in the solar cell module, the sodium blocking layer prevents sodium from reaching the solar cell elements. In the case of the solar cell elements including a p-type semiconductor layer, activity of p-type impurities in the p-type semiconductor is not discouraged by the sodium. As a result, output-characteristics reduction of the solar cell module is prevented.

BRIEF DESCRIPTION OF THE DRAWINGS

FIG. 1 is a cross sectional view showing the structure of a solar cell element according to an embodiment of the present invention.

FIG. 2 is a cross sectional view showing the structure of a solar cell module using the solar cell elements according to the embodiment shown in FIG. 1.

FIG. 3 is a cross sectional view to describe a manufacturing process of the solar cell element according to the embodiment of the present invention.

FIG. 4 is a cross sectional view to describe a manufacturing process of the solar cell element according to the embodiment of the present invention.

FIG. 5 is a schematic view showing collector electrodes of the solar cell element according to the embodiment of the present invention.

FIG. 6 is a schematic view showing electrically-conductive paste according to the embodiment of the present invention.

FIG. 7 is a schematic view to describe an instrument for measuring connecting tab strength.

FIG. 8 is a cross sectional view showing the structure of a solar cell module according to Example 1-1 of a second solar cell module in the present invention.

FIG. 9 is a diagram of a measuring apparatus shown to describe a measuring procedure of a water vapor transmission rate of the rear surface protective member.

FIG. 10 is a schematic view to describe a test procedure of an evaluation test of insulation performance.

FIG. 11 is a cross sectional view showing the structure of a solar cell module according to Example 2-6 of the second solar cell module in the present invention.

FIG. 12 is a cross sectional view showing the structure of a solar cell module according to Example 2-7 of the second solar cell module in the present invention.

FIG. 13 is a cross sectional view showing the structure of a solar cell module according to Example 2-15 of the second solar cell module in the present invention.

FIG. 14 is a cross sectional view showing the structure of a solar cell module according to Example 2-22 of the second solar cell module in the present invention.

FIG. 15 is a cross sectional view showing the structure of a solar cell module according to Example 3-2 of the second solar cell module in the present invention.

FIG. 16 is a cross sectional view showing the structure of a solar cell module according to Example 3-3 of the second solar cell module in the present invention.

FIG. 17 is a cross sectional view showing the structure of a solar cell module according to Example 3-4 of the second solar cell module in the present invention.

FIG. 18 is a cross sectional view showing the structure of a solar cell module according to Example 3-6 of the second solar cell module in the present invention.

FIG. 19 is a cross sectional view showing the structure of a conventional solar cell module.

FIG. 20 is a cross sectional view showing the structure of one example of solar cell elements used in the typical solar cell modules.

FIG. 21 is a plane showing the structure of one example of solar cell elements used in the typical solar cell modules.

DETAILED DESCRIPTION OF THE PREFERRED EMBODIMENT(S)

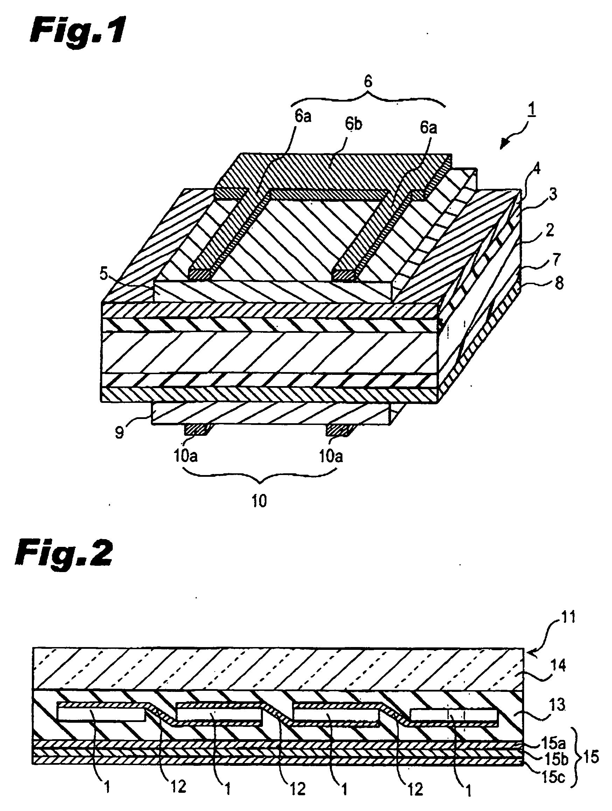

Embodiments of the present invention will be described below with reference to drawings. FIG. 1 is a cross sectional view showing the structure of a solar cell element according to the embodiment of the present invention. FIG. 2 is a cross sectional view showing the structure of a solar cell module using the solar cell elements of the embodiment shown in FIG. 1.

Referring to FIGs. 1 and 2, firstly the structure of a solar cell element and a solar cell module (solar cell apparatus) using thereof according to the embodiment will be described.

The solar cell element 1 of the embodiment, as shown in FIG. 1, has resistivity of about 1 $\Omega$ cm and a thickness of about 300 $\mu$m and comprises an n-type single crystal silicon substrate having a (100) plane 2 (hereinafter referred to as "n-type single crystal silicon substrate 2"). There are pyramidal projections and depressions having a height of a few micro meters to a few tens of micro meters on a surface of the n-type single crystal silicon substrate 2. An i-type amorphous silicon layer 3, which is substantially intrinsic and has a thickness of about 5 nm, is formed on the n-type single crystal silicon substrate 2. A p-type amorphous silicon layer 4 having a thickness of about 5 nm is formed on the i-type amorphous silicon layer 3.

On the p-type amorphous silicon layer 4 formed is an ITO film 5 having a thickness of about 100 nm and serving as a transparent conductive film. The ITO film 5 is formed of $In_2O_3$ added with $SnO_2$ In order to improve the light-tranamissivity of the ITO film 5, Sn content in the ITO film 5 is preferably set about 5 wt.% or less, more preferably about 2 wt.% or less.

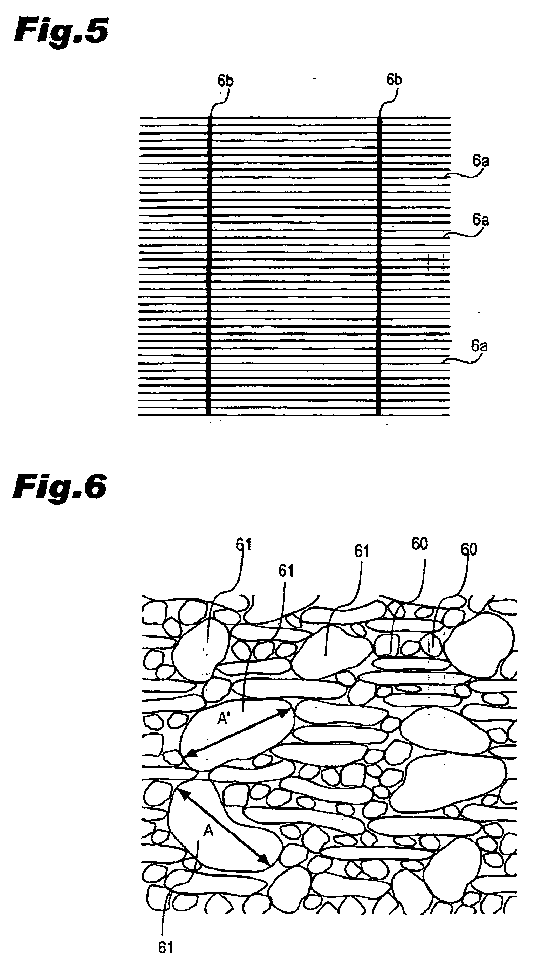

A collector electrode (paste electrode) 6 is formed at a predetermined region on an upper surface of the ITO film 5. The collector electrode 6 is comprised of an electrically-conductive filler made of silver (Ag) and thermosetting resin. The thermosetting resin in the collector electrode 6 contains epoxy resin at ratio from 70% to 90% by volume. The other resin component in the resin binder is all urethane resin. The collector electrode 6 is comprised of finger portions 6a and bus bar portions 6b as shown in FIGs. 1 and 5.

A substantially intrinsic i-type amorphous silicon layer 7 having a thickness of about 5 nm is formed on a lower surface of the n-type single crystal silicon substrate 2. On the i-type amorphous silicon layer 7 formed is an n-type amorphous silicon layer 8 having a thickness of about 20 nm. By forming the i-type amorphous silicon layer 7 and the n-type amorphous silicon layer 8 in this order on the lower surface of the n-type single crystal silicon substrate 2, the so-called BSF (Back Surface Field) structure is created. An ITO film 9 having a thickness of about 100 nm is formed on the n-type amorphous silicon layer 8. A collector electrode (paste electrode) 10 is formed on a predetermined region on the ITO film 9. Except for the above-described features of the i-type amorphous silicon layer 7, the n-type amorphous silicon layer 8, the ITO film 9, and the collector electrode 10 on the lower surface of the n-type single crystal silicon substrate 2, other features thereof are same as the features of the i-type amorphous silicon layer 3, the p-type amorphous silicon layer 4, the ITO film 5 and the collector electrode 6 on the upper surface of the n-type single crystal silicon substrate 2.

In this embodiment, an ITO film is used as a transparent conductive film, however, other transparent conductive films, for example a ZnO film, are also available.

The solar cell module 11 according to the embodiment, as shown in FIG. 2, comprises a plurality of solar cell elements 1. Each of the plurality of solar cell elements 1 is connected to adjacent solar cell element 1 in series by connecting tabs 12, which are flat copper films coated with Sn-Ag-Cu solder. One end of the tab 12 is connected to a collector electrode 6 (see FIG. 1) on a upper surface of a given solar cell element 1, while the other end of the tab 12 is connected to a collector electrode 10 (see FIG. 1) on a lower surface of another solar cell element 1 adjacent to the given solar cell element 1.

The plurality of solar cell elements 1 connected to each other by the tabs 12 are encapsulated with EVA (Ethylene Vinyl Acetate) sealant 13. A front surface protective member 14, which is a glass substrate, is formed on an upper surface of the sealant 13. On a lower surface of the sealant 13 formed is a rear surface protective member 15 having a three-layer structure of a PET (Polyethylene Terephthalate) layer 15a / aluminum foil 15b / a PET layer 15c.

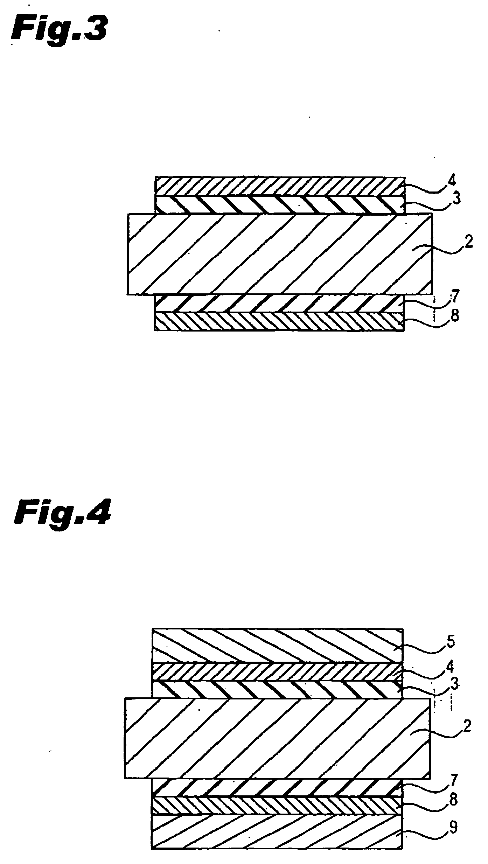

FIG. 3 and FIG. 4 are cross sectional views to describe a manufacturing process of the solar cell element according to the embodiment. Referring to FIGs. 1, 3 and 4, the manufacturing process of a solar cell element and a solar cell module using thereof according to the embodiment will be described.

Firstly, an n-type single crystal silicon substrate 2 having resistivity of about 1 $\Omega$cm and a thickness of about 300 $\mu$m with impurities removed by cleaning is prepared as shown in FIG. 3. An i-type amorphous silicon layer 3 of about 5 nm in thickness and a p-type amorphous silicon layer 4 of about 5 nm in thickness are then formed in this order on an upper surface of the n-type single crystal silicon substrate 2 by an RF plasma CVD method. The specific conditions for forming the i-type amorphous silicon layer 3 and the p-type amorphous silicon layer 4 by the RF plasma CVD method arse indicated as follows: Frequency: about 13.56 MHz, temperature: about 100°C to 250°C, pressure: about 26.6 Pa to 80.0 Pa, RF power: about 10 W to 100 W.

In addition, an i-type amorphous silicon layer 7 of about 5 nm in thickness and an n-type amorphous silicon layer 8 of about 20 nm in thickness are formed in this order on a lower surface of the n-type single crystal silicon substrate 2. The process for forming the i-type amorphous silicon layer 7 and the n-type amorphous silicon layer 8 are same as that for the i-type amorphous silicon layer 3 and the p-type amorphous silicon layer 4.

Subsequently, as shown in FIG. 4, ITO films 5 and 9 each having a thickness of about 100 nm are formed on the p-type amorphous silicon layer 4 and the n-type amorphous silicon layer 8 respectively by a magnetron sputtering method. The specific conditions for forming the ITO films 5 and 9 are indicated as follows: Temperature: about 50°C to 250°C, Ar gas flow: about 200 sccm, $O_2$ gas flow: about 50 sccm, power: about 0.5 kW to 3 kW, magnetic field strength: about 500 Gauss to 3000 Gauss.

Next, electrically-conductive paste (silver paste (low heat curing paste)), which is a feature of the present invention, composed of electrically-conductive powder, for example silver (Ag), and thermosetting resin (epoxy resin and urethane resin are contained at a predetermined volume ratio) is applied to predetermined regions on each of the ITO films 5 and 9 by screen printing and then is burned at a temperature of about 180°C for about one hour to be cured. Thus collector electrodes 6 and 10 are formed. The solar cell element 1 shown in FIG. 1 of this embodiment is formed in this way.

A plurality of solar cell elements 1 thus formed are prepared. One end of a connecting tab 12 (see FIG. 2) comprising copper foil is connected to a collector electrode 6 on the upper surface of the plurality of the solar cell elements 1. The surfaces of the copper foil of the tab 12 are coated with Sn-Ag-Cu based lead (Pb) free solder.

The connecting tab 12 is connected to the collector electrode 6 by heating the Sn-Ag-Cu solder coating the surfaces of the tab 12 and soldering the tab 12 to the collector electrode 6. Another end of the connecting tab 12 is connected to a collector electrode 10 (see FIG. 1) on a lower surface of an adjacent solar cell element 1 through the same process. In this way, the plurality of solar cell elements 1 are connected to each other in series.

After a sealant 13, which is an EVA sheet, is put on a front surface protective member 14 comprised of a glass substrate, the plurality of solar cell elements 1 connected to each other by the connecting tabs 12 are placed on the sealant 13. Furthermore a sealant 13, which is an EVA sheet, is put on the solar cell elements 1, then a rear surface protective member 15 having a three-layer structure of a PET / aluminum foil / a PET is placed. The front surface protective member 14, the sealant 13, the plurality of solar cell elements 1 connected by the tabs 12 and the rear surface protective member 15 are heated and pressurized under a reduced pressure to be one piece. In this way, the solar cell module 11 according to the embodiment as shown in FIG. 2 is formed.

When the connecting tab composed of Sn-Ag-Cu solder is used as described above, the electrically-conductive paste (silver paste) is required to have an improved heat resistant property. Inventors of the present invention focused on the heat resistance and found out that the volume ratio of epoxy resin having a glass transition temperature in a range of 80°C to 200°C measured by the TMA method to resin included in the thermosetting resin contributes to the heat resistance of entire resin. Now descriptions will be made on the glass transition temperature. When a high polymer material is heated, the polymer is changed from a glassy rigid state to a rubbery state. This phenomenon is called glass transition. The temperature at which the glass transition takes place is termed the glass transition temperature, or Tg. There are many methods of measuring the glass transition temperature. In the present invention, aTMA (Thermo-mechanical analysis) method was adopted. In the TMA method, a specimen is heated from a room temperature and the temperature is increased by 10°C per minute and thermal expansion of the specimen is measured along its thickness by a thermomechanical analyzer. Then the relationship between the temperature and thermal expansion is represented as a curve chart. A line extended from a starting part of the curve intersects with a line extended from an ending part of the curve. The glass transition temperature is obtained from the intersection point of the lines.

When a connecting tab, which is composed of Sn-Ag-Cu based lead (Pb) free solder, is soldered to a collector electrode, epoxy resin having a glass transition temperature in a range of 80°C to 200°C should be contained at the volume ratio of 70vol% to 90vol%. If such a resin is contained at volume ratio of 70 percent -90 percent strength between the connecting tab and the cell after soldering is improved, and a proportion defective caused by the tab removal in a modularizing process greatly decreases.

When a connecting tab coated with lead (Pb) free solder is soldered to a conductive paste containing resin having a glass transition temperature below 80°C, defectives such as tab removal caused by the embrittled silver paste and degradation in moisture resistance of the module occur. When using a conductive paste containing resin having a glass transition temperature over 200°C at a volume ratio of 50% or more, it is impossible to solder a lead (Pb) free tab to the conductive paste.

Samples were made as follows. In this embodiment, an HIT structure solar cell element using a single crystal silicon wafer of 104 mm per side was employed. The collector electrode pattern (design of a screen) employed herein has the bus bar portions 6b on a light incident side of 1.5 mm in width (width of an aperture) and finger portions 6a of 80 $\mu$m in width (width of an aperture) (see FIG. 5).

In this test conducted in the embodiment, silver pastes with thermosetting resin composed of epoxy resin and urethane resin were prepared. The volume ratio of epoxy resin in the silver pastes was 30 vol.%, 50vol.%, 70 vol.%, 80 vol.%, 90 vol. % and 100 vol.% each. The epoxy resin in this test was bisphenol-A epoxy resin.

The glass transition temperature of the epoxy resin used herein was 90°C and the glass transition temperature of the urethane resin was 40°C as a result of measurement by the TMA.

These pastes were blended with 85 wt.% or more silver powder and its specific resistance was $3 \times 10^{-5}$ $\Omega$cm or less. Thus, as shown in FIG. 6, the silver powder was comprised of approximately granulated filler 60 of 5 $\mu$m or less in diameter and flaky filler 61 having a maxim length (indicated by A or A' in FIG. 6) of 20 $\mu$m or less. The silver powder contained 40 wt.% approximately granulated powder filler 60.

HIT structure solar cell elements in which collector elettrodes were formed with the above silver paste were prepared, and tabs each coated with eutectic solder and (Sn-Ag-Cu solder) were soldered to the collector electrodes respectively. Then tests were conducted of adhesion strength between the solar cell element and the tab and of moisture resistance of the module using the solar cell elements.

Regarding the samples, data of adhesion strength between the solar cell element and the tab are shown in Table 1, and the incidence of defects in a post-process resulting from lack of adhesion strength is shown in Table 2. Note that there is no data of the incidence of defects in the post-process for the solar cell with silver paste containing 30 vol.% epoxy resin, because of its high incidence of defects.

Tab strength herein means pull strength obtained when a copper film foil soldered to a collector electrode of a solar cell element is pulled off. This tab strength could be an index of adhesion of a collector electrode to an ITO film. To measure the tab strength, CPU Gauge Model-9500 (Aikoh Engineering Co., Ltd.) was used.

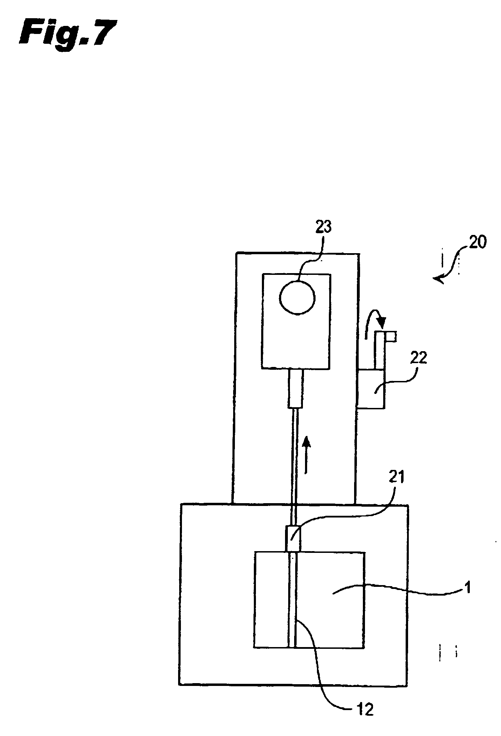

As shown in FIG. 7, a solar cell element 1 was fixed in a pull strength gauge instrument 20. A clip 21 of the pull strength gauge instrument 20 caught a connecting tab 12 soldered on a collector electrode 6 of the solar cell element 1 (see FIG. 1). Turning a handle 22 of the pull strength gauge instrument 20 pulled the clip 21 until the tab 12 and the collector electrode 6 were pulled off the solar cell element 1. The tab strength was thus measured by obtaining the maximum value of the pull strength indicated on a gauge 23 of the pull strength gauge instrument 20.

The incidence of defects was obtained by checking visually and counting the number of the tab 12 and the collector electrode 6 pulled off the solar cells when the solar cells connected in series through the tabs soldered were placed on a glass/EVA sheet. Specifically, in the post-process, 24 solar cell elements were connected in series in a line, 4 lines of the solar cell elements were connected in parallel, and then the 4 lines of solar cell elements were placed on the glass/EVA sheet. At this time, the visual check was performed and counted even one removal as a defective.

[Table 1]

| Epoxy ratio | 30 vol% | 50 vol% | 70 vol% | 80 vol% | 90 vol% | 100 vol% |
|---|---|---|---|---|---|---|
| Eutectic solder | 100g | 100g | 100g | 100g | 100g | 100g |
| Pb free solder | 30g | 50g | 80g | 100g | 100g | 100g |

[Table 2]

| Epoxy ratio | 50 vol% | 70 vol% | 80 vol% | 90 vol% | 100 vol% |
|---|---|---|---|---|---|
| Eutectic solder | 0.1% | 0.1% | 0.1% | 0.1% | 1% |
| Pb free solder | 15% | 1% | 0.1% | 0.1% | 1% |

From Table 1 and Table 2, it is found that when using connecting tabs coated with lead (Pb) free solder the desirable compound ratio of epoxy is 70 vol.% to 90 vol.%. When a silver paste containing 100 vol.% epoxy was used, the incident of defects in the post-process increases in spite of excellent tab strength. This is because the silver paste containing only epoxy resin becomes harder, thereby causing the removal of the tab. Therefore, it can be concluded that the compound ratio of epoxy is preferably over 70 vol.%, but it is necessary to add urethane resin in some degree. As a result, it can be concluded that the compound ratio of epoxy resin is 70 vol.% to 90 vol.%.

Next descriptions will be about the measurements of the moisture resistance of modules. Modules, as shown in FIG. 2, using the solar cell elements according to the embodiment are formed to evaluate their moisture resistance. The results (ratio of final output to initial output) are indicated in Table 3 below. The moisture test was conducted under the condition of JIS C 8917:1918 Annex 11 (normative) Damp hear steady state test B-2. JIS C 8917:1918 Annex 11 (normative) Damp hear steady state test B-2 specifies the test as follows:

1. Purpose The purpose of this test is to examine the aptitude of modules used and stored under the conditions of high temperature and humidity.

2. Equipment The Equipment used for this test shall be as specified in 2 of JIS C 0022. The temperature shall be 85°C $\pm$ 2°C and the relative humidity shall be 85% $\pm$ 5%.

3. Test method The test condition shall be such that the temperature is 85°C $\pm$ 2°C, the relative humidity is (85 $\pm$ 5)% and the duration of test is 1000 h $\pm$ 12 h (about 42 days).

4. Preparation The sealing of stranded wire terminations of the specimen shall be treated as in actual service conditions or adequately protected to prevent abnormal corrosion. A mini-module having the characteristics same as those of the module to be tested may be used as the specimen.

5. Test procedures Prior to the test, measure the electrical performances specified in 6.1 of JIS C 8918 of the specimen, visually examine the appearance and then test the specimen by means of the equipment specified in 2 for 1000 h $\pm$ 12 h (about 42 days) in accordance with the provision of 4.3 in JIS C 0022. If water drops are adhering on the specimen after the test, remove them completely with clean cloth or the like, allow the specimen to stand under the standard atmospheric conditions for 24 h, measure the electrical performances specified in 6.1 of JIS C 8918, and then visually check the appearance.

6. Items to be specified in detail specifications The following items shall be specified in detail specifications:

(1) Initial measurement items (if necessary) (see 5)

(2) Final measurement items (if necessary) (see 5)

In conformance with JIS C 8917:1918, a test chamber was kept at a temperature of 85°C and at a humidity of 85%. The modules were stored in the test chamber and measured for their output after 1000 hours and 2000 hours. In the JIS test, it is stipulated that the modules is stored for 1000 hours and the acceptable output ratio to the initial output is 95% or more. In our test, the period was extended to 2000 hours to evaluate the moisture resistance for the longer time. For reference purposes, output ratios (to the initial output) of the modules in 1000 hours are indicated in parentheses in Table 3.

The solar cell element with silver paste containing 30% epoxy was not evaluated because the tabs were removed just after soldering thereof.

[Table 3]

| Epoxy ratio | 50 vol% | 70 vol% | 80 vol% | 90 vol% | 100 vol% |
|---|---|---|---|---|---|
| Eutectic solder | 96(98)% | 97(99)% | 97(99)% | 98(99)% | 99(99.5)% |
| Pb free solder | 94(95)% | 96(97)% | 97(99)% | 98(99)% | 99(99.5)% |

As shown in Table 3, it is apparent that the solar cell modules having higher compound ratio of epoxy can reduce the output drop after the moisture test regardless of the type of solder. Even the solar cell module having a combination of lead (Pb) free solder and 50% epoxy resin-containing paste meets the JIS standard (the ratio of final Pmax to the initial Pmax shall be 95% or more), but it is not suitable for mass production because the value is close to the floor limit of the JIS standard which may cause unstable productivity.

Especially, the solar cell modules with silver paste containing 70 vol.% or more epoxy resin can reduce its output drop after the longer-period moisture test (2000 hours). Furthermore, the silver paste becomes less brittle when soldered with lead (Pb) free solder.

In the above samples, thermosetting resin containing 70 vol.% epoxy resin and 40 wt.% granulated filler 60 (see FIG. 6) were used. Next samples were formed with thermosetting resin containing 70 vol.% epoxy resin and different compound ratio of the granulated filler 60 such as 0, 20, 40, 60, 80, 100 wt.%. The evaluation thereof is shown in Table 4 below.

[Table 4]

| Granulated filler ratio (wit.%) | 0 | 20 | 30 | 40 | 50 | 60 | 80 | 90 | 100 |
|---|---|---|---|---|---|---|---|---|---|
| Incomplete print | × | × | Δ | ○ | ○ | ○ | ○ | ○ | ○ |
| Specific resistance | ○ | ○ | ○ | ○ | ○ | ○ | ○ | × | × |

In the "incomplete print" row of Table 4, the × represents that an incomplete print occurred after continuously printing samples 50 times, the Δ represents that a miniscule incomplete print occurred after continuously printing samples 50 times. In the "specific resistance" row of Table 4, the × represents that the specific resistance was $5 \times 10^{-5}$ Ωcm or more. In both rows, the O represents that the samples were in good condition.

From Table 4, it is apparent that the sample containing 30 wt.% or less granulated filler 60 is not suitable for the paste of solar cells due to the occurrence of incomplete print. It is also apparent that the sample containing 90 wt.% or more granulated filler 60 is not suitable for the paste of solar cells due to a rise of the specific resistance. Therefore, the suitable compound ratio of the granulated filler 60 is 40 wt.% to 80 wt.%.

There was no difference in printability according to the compound ratio of the granulated filler 60, even when the compound ratio of epoxy varied between 50 vol.% and 100 vol.%

In addition, silver pastes made with resins containing 70 vol.% epoxy resins each having a glass transition temperature of 70°C, 80°C, 150°C, 200°C, and 210°C were prepared and the same test was conducted to obtain the results in Table 3. The results are shown in Table 5. For reference purposes, output ratios (to the initial outputs) of the modules after 1000 hours are indicated in parentheses in Table 5.

[Table 5]

| Glass transition temperature | 70°C | 80°C | 90°C | 150°C | 200°C | 210°C |
|---|---|---|---|---|---|---|
| Tab strength | 30g | 50g | 80g | 100g | 80g | - |

(continued)

| Glass transition temperature | 70°C | 80°C | 90°C | 150°C | 200°C | 210°C |
|---|---|---|---|---|---|---|
| Incidence of defects | - | 15% | 1% | 0.1% | 1% | - |
| Moisture resistance | - | 94(95)% | 96(97)% | 98(99)% | 96(97)% | - |

The incidence of defects and moisture resistance for the sample (70°C) were not evaluated. It was also impossible to evaluate the incidence of defects and moisture resistance for the solar cell using paste having the glass transition temperature of 210°C, because the connecting tabs could not be soldered to the paste. Therefore these values are not shown in Table 5.

As shown in Table 5, the connecting tabs coated with Sn-Ag-Cu solder can be soldered to pastes with epoxy resins having glass transition temperature in a range between 80°C and 200°C. The pastes with epoxy resins having the glass transition temperature in a range between 90°C and 200°C have excellent moisture resistance. Therefore the practical range of glass transition temperature is between 90°C and 200°C.

In the above tests, bispheaol-A epoxy resin was used. However, the following epoxy type resins also have the same effect as bisphenol-A epoxy resin: epoxy resing derived from bifunctional compounds based on stilbene and biphenyl; epoxy resing derived from potyfunctional compounds based on polyphenol and phenol novolac; and epoxy resin derived from polyaddition products based on dicyclopentadiene or phenol.

In the above teats, silver was used as electrically-conductive fillers. Any kinds of conductive fillers can be used including metal such as copper, nickel and aluminum and carbon.

In the above described embodiment, a three-layer structure of a PET layer 15a / aluminum foil 15b / a PET layer 15c is used as a rear surface protective member 15. The solar cell module of this structure is termed "first solar cell module" herein. The three layers with Al foil sandwiched can prevent water from permeating from the rear surface. Next embodiment, which will be described below, is a solar cell module using a rear surface protective member without metal materials such as Al foil, while preventing degradation in moisture resistance and yield reduction.

The rear surface protective member not including metal material such as Al foil has a relatively high water vapor transmission rate. If a lot of water permeates the electrically-conductive paste forming the collector electrodes, resin contained in the conductive paste is hydrolyzed by the water, thereby increasing in contact resistance of the collector electrode. Inventors of the present invention found out that it is possible to prevent degradation in moisture resistance and yield reduction of the solar cell module, which uses electrically-conductive paste containing thermosetting resin including epoxy resin and electrically-conductive powder, by controlling an amount of epoxy resin according to the water vapor transmission rate of the protective layer. Now, descriptions will be made on embodiments of solar cell module using a rear surface protective member without metal materials such as Al foil (hereinafter referred to as second solar cell module).

[Embodiment 1 of second solar cell module]

In this embodiment 1, solar cell modules were prepared with variation in compound ratio of epoxy resin, which was a material forming collector electrodes, for Examples 1-1 to 1-5 and Comparative examples 1-1 to 1-5. On each solar cell module, a temperature cycle test, a dump heat steady state test, and an evaluation test of insulation performance were conducted.

[Example 1-1] not falling under the claimed invention

The solar cell element 1 is as same as that shown in FIGs. 1, 3 and 4. That is, as described above, a substantially intrinsic i-type amorphous silicon layer 3, a p-type amorphous silicon layer 4 are subsequently formed on an n-type single crystal silicon substrate 2.

In addition, an ITO film 5 is formed on the p-type amorphous silicon layer 4. A collector electrode (paste electrode) 6 is formed at a predetermined region on an upper surface of the ITO film 5. The collector electrode 6 is comprised of an electrically-conductive filler made of silver (Ag) and thermosetting resin. The thermosetting resin in the collector electrode 6 contains epoxy resin at ratio of 50% by volume. The other resin component in the resin binder is all urethane resin.

On a lower surface of the n-type single crystal silicon substrate 2 formed are an i-type amorphous silicon layer 7 and an n-type amorphous silicon layer 8 in this order. An ITO film 9 is formed on the n-type amorphous silicon layer 8. A collector electrode (paste electrode) 10 is formed at a predetermined region on an upper surface of the ITO film 9. Except for the above-described features of the i-type amorphous silicon layer 7, the n-type amorphous silicon layer 8, the ITO film 9, and the collector electrode 10 on the lower surface of the n-type single crystal silicon substrate 2, other features thereof are same as the features of the i-type amorphous silicon layer 3, the p-type amorphous silicon layer 4, the ITO film 5 and the collector electrode 6 on the upper surface of the n-type single crystal silicon substrate 2.

The collector electrodes 6 and 10 are formed by screen printing. Electrically-conductive paste (silver paste) comprising electrically-conductive filler made of silver (Ag) and resin materials (bisphenol-A epoxy resin : urethane resin = 50 vol.% : 50 vol.%) is applied at predetermined regions on an upper surface of the light-transmitting conductive film 9 and a lower surface of the light-transmitting conductive film 5. The conductive pastes are cured by drying at 200°C for one hour. Thus, the collector electrode 6 comprising finger portions 6a of 80 $\mu$m in width and bus bar portions 6b of 1.5 mm in width is formed on the upper surface of the light-transmitting conductive film 5, while the collector electrode 10 comprising finger portions 10a and bus bar portions (not shown), which have the same configuration as the finger portions 6a and the bus bar portions 6b, is formed on the lower surface of the light-transmitting conductive film 9. The bisphenol-A epoxy resin has a glass transition temperature in a range between 100°C and 160°C, which is within a range between 80°C and 200°C of suitable soldering temperature when the connecting tabs are connected by lead free solder. The glass transition temperature (Tg) of epoxy resin-cured products depends on cross-link density and molecular structure. The higher cross-link and the more rigid structure the molecular of the cured product has, the higher glass transition temperature of the cured product is. In other word, the glass transition temperature of the product can be changed by changing design of the distance between the cross-link points and flexibility of the molecule structure. The glass transition temperature of the bisphenol-A epoxy resin obtained by the TMA method is 90°C, while urethane resin is 40°C.

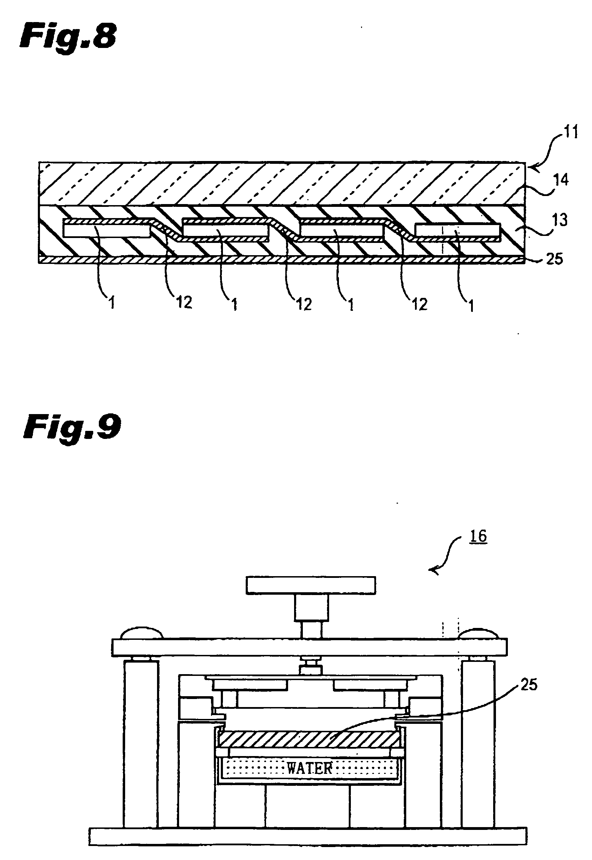

A plurality of solar cell elements 1 thus formed are prepared. One end of a connecting tab 12 (see FIG. 8) comprising a copper foil is connected to a bus.bar portion 6b of the collector electrode 6 on an upper surface of the solar cell element 1. The connection of the tab 12 and the bus bar portion 6b is carried out by heating lead (Pb) free solder (Sn-Ag-Cu solder was used herein) coating the surface of the tab 12 and soldering the tab 12 to the bus bar portion 6b. Another end of the tab 12 is connected to a bus bar portion (not shown) of a collector electrode 10 on a lower surface of adjacent solar cell element 1 through the same process. In this way, the plurality of solar cell elements 1 are connected in series.

After the sealant 13, which is an EVA (Ethylene Vinyl Acetate) sheet, is put on a front surface protective member 14 comprised of a glass substrate, the plurality of solar cell elements 1 connected to each other by the connecting tabs 12 are placed on the sealant 13. Furthermore a sealant 13, which is an EVA sheet, is put on the solar cell elements 1, then a rear surface protective member 25 comprised of a single layer film of PET (Polyethylene Terephthalate) having a thickness of 30 $\mu$m is placed. Note that the rear surface protective member 25 is one example of "rotective layers" of the present invention. The front surface protective member 14, the sealant 13, the plurality of solar cell elements 1 connected by the tabs 12 and the rear surface protective member 25 are heated and pressurized under reduced pressure to be one piece. In this way, the solar cell module 11 according to Example 1-1 shown in FIG. 8 is fabricated.

Prior to the integration of the rear surface protective member 25, water vapor transmission rate thereof was measured by a humidity detection sensor method described in JIS K 7129:1992 (Testing methods for water vapor transmission rate of plastic film and sheeting (instrument method)). JIS K 7129:1992 specifies the method as follows:

3. (1) A method (Humidity detection sensor method) Set up the condition that one side of a test piece is filled with saturated water vapor and the other side with specified relative humidity. Detect the change of humidity, by a humidity detection sensor set at low humidity side, brought by water vapor transmitted through the test piece, and then transducer the signal into an electric one. Measure the time by which the specified unit difference of the relative humidity of water vapor takes place, and calculate the water vapor transmission rate from the value after confirmation that the water vapor transmission rate is at a steady condition.
6. A method (Humidity detection sensor method)

6.1 Apparatus for test

An example of measuring apparatus for water vapor transmission rate by humidity detection sensor method is shown in Fig. 1. The main part of the testing apparatus is composed of a transmission cell which has two measuring cells such as lower high-humid side and upper low-humid side respectively, a humidity sensor for detecting the amount of transmitted water vapor as a relative humidity, a pump for providing dried air, a tube for drying, and a water reservoir.

(1) The transmission cell is composed of an upper measuring cell and lower measuring cell between which a test piece is inserted, and the lower cell has high relative-humidity surroundings which is directly connected to the water reservoir. The upper cell is constructed to accumulate water vapor passed through the test piece from the high humidity side, and the humidity detection sensor is mounted over this cell. The area for transmission shall be 5 to 100 cm$^2$.
The transmission cell shall be kept $\pm$ 0.5°C by means of a temperature controller.

(2) The humidity detection sensor should be able to detect humidity change of 0.05%RH, and its response speed should be not more than 1 second.

Remarks : The maintenance and deterioration of a humidity detection sensor shall follow an instruction manual since they are different according to the type of a humidity detection sensor.

(3) The pump is for sending dried air into an upper cell, and the tube for drying is packed with desiccant.

(4) The water reservoir is directly connected with the lower cell, and can reserve distilled water. About 5 mm thick air layer should be provided between its water surface and the test piece.

6.2 Test condition

Test condition should be chosen from the following.

(1) Test temperature 25 $\pm$ 0.5°C, difference of relative humidity (90 $\pm$ 2) %RH
(2) Test temperature 40 $\pm$ 0.5°C, difference of relative humidity (90 $\pm$ 2) %RH
(3) Test temperature 25 $\pm$ 0.5°C, difference of relative humidity (75 $\pm$ 2) %RH The test conditions other than these shall follow the agreement between the parties concerned.

Remarks : Because the lower cell is kept at 100%RH relative humidity with saturated water vapor, if the difference of relative humidity if to be set as 90%RH (75%RH), the humidity of a upper cell should be set 10%RH (25%RH).

6.3 Operations

The water vapor transmission rate for a standard specimen and the test piece shall be measured as following.
It is preferable that the water vapor transmission rate of the standard specimen is periodically tested.

(1) Put hermetically a specified amount of distilled water into the lower cell.
(2) Insert either a standard specimen or test piece between the upper cell and lower cell. In this case it should be mounted so that there are no wrinkles or slack on its surface.
(3) Make the humidity in the upper cell 10%RH or less relative humidity using dried air, and start measuring.
(4) Measure the increment of relative humidity owing to the water vapor passed through the test piece using the humidity detector sensor, and repeat the measurements until the time required to recover the unit humidity difference by increment of water vapor becomes a constant value which is $\pm$ 5% or less[2].

Note[2] This $\pm$ 5% is principally decided, and if the measurement exceeds this, the result should be annexed in the record.

6.4 Calculation

The water vapor transmission rate shall be calculated according to the flowing formula.

$$\text{WVTR} = \frac{S \times C}{T} \times F$$

where, WVTR: water vapor transmission rate of test piece [g/(m$^2$·24h)]
S: water vapor transmission rate of standard specimen [g/(m$^2$·24h)]
C: required time for unit relative humidity difference of standard specimen (s)
T: required time for unit relative humidity difference of test piece (s)
F: transmission area of standard specimen/transmission area of test piece

The water vapor transmission rate was measured by a measuring apparatus 16 as shown in FIG. 9. Specaficavy, the rear surface protective member 25 was set in the measuring apparatus 16 and water was prepared below the rear surface protective member 25. The lower side of the rear surface protective member 25 was exposed to an atmosphere of a temperature of 40°C and a humidity of 100%, while the upper side was exposed to an atmosphere of a temperature of 40°C and a humidity of 10% (initial humidity at the start of measurement). As keeping it in this state, water vapor permeates the rear surface protective member 25. Then the change rate of humidity on the upper side of the rear surface protective member 25 was measure by a humidity detection sensor. By comparing the measured change rate of humidity to the change rate of humidity of a standard specimen whose water vapor transmission rate has been know previously, the water vapor transmission rate of the rear surface protective member 25 was obtained. The water vapor transmission rate of the rear surface protective member 25 of Example 1-1 was 15 g/m$^2$·24hrs (40°C, 90%).

[Example 1-2]

In Example 1-2, resin material containing 70 vol.% bisphenol-A epoxy resin and 30 vol.% urethane resin is used for the conductive paste (silver paste) to form the collector electrodes 6 and 10. Except for this, the solar cell module of Example 1-2 is fabricated as in Example 1-1.

[Example 1-3]

In Example 1-3, resin material containing 90 viol.% bisphenol-A epoxy resin and 10 vol.% urethane resin is used for the conductive paste (silver paste) to form the collector electrodes 6 and 10. Except for this, the solar cell module of Example 1-3 is fabricated as in Example 1-1.

[Example 1-4] not falling under the claimed invention

In Example 1-4, resin material containing 98 vol.% bisphenol-A epoxy resin and 2 vol.% urethane resin is used for the conductive paste (silver paste) to form the collector electrodes 6 and 10. Except for this, the solar cell module of Example 1-4 is fabricated as in Example 1-1.

[Example 1-5] not falling under the claimed invention

In Example 1-5, resin material containing 100 vol.% bisphenol-A epoxy resin and 0 vol.% urethane resin is used for the conductive paste (silver paste) to form the collector electrodes 6 and 10. Except for this, the solar cell module of Example 1-5 is fabricated as in Example 1-1.

[Comparative example 1-1]

In the Comparative example 1-1, as shown in FIG. 2, a film having a three-layer structure of a PET layer 15a (thickness: 30 $\mu$m) / Al foil 15b (thickness: 30 $\mu$m) / a PET layer 15c (thickness: 30 $\mu$m) is used as the rear surface protective film 15. This Comparative example 1 corresponds to the first solar cell module in the present invention. The water vapor transmission rate of the rear surface protective member 15 is 0 g/m$^2$·24hrs (40°C, 90°C). Except for this, the solar cell module of Comparative example 1-1 is fabricated as in Example 1-1.

[Comparative example 1-2]

In Comparative example 1-2, resin material containing 70 vol.% bisphenol-A epoxy resin and 30 vol.% urethane resin is used for the conductive paste (silver paste) to form the collector electrodes 6 and 10. Except for this, the solar cell module of Comparative example 1-2 is fabricated as in Example 1-1.

[Comparative example 1-3]

In Comparative example 1-3, resin material containing 90 vol% bisphenol-A epoxy resin and 10 vol.% urethane resin is used for the conductive paste (silver paste) to form the collector electrodes 6 and 10. Except for this, the solar cell module of Comparative Example 1-3 is fabricated as in Example 1-1.

[Comparative example 1-4]

In Comparative example 1-4, resin material containing 98 vol.% bisphenol-A epoxy resin and 2 vol.% urethane resin is used for the conductive paste (silver paste) to form the collector electrodes 6 and 10. Except for this, the solar cell module of Comparative example 1-4 is fabricated as in Example 1-1.

[Comparative example 1-5]

In Comparative example 1-5, resin material containing 100 vol% bisphenol-A epoxy resin and 0 vol.% urethane resin is used for the conductive paste (silver paste) to form the collector electrodes 6 and 10. Except for this, the solar cell module of Comparative example 1-5 is fabricated as in Example 1-1.

[Thermal cycling test]

The solar cell modules fabricated in Examples 1-1 to 1-5 and Comparative examples 1-1 to 1-5 were submitted to a thermal cycling test. The thermal cycling test was conducted in compliance with JIS C 8917:1998 Annex 1 (normative) Thermal cycling test A-1. JIS C 8917:1998 Annex 1 (normative) Thermal cycling test A-1 specifies the test as follows:

1. Purpose

The purpose of this test is to determine the ability of the module to withstand repeated rapid change of temperature.

2. Equipment

The test chamber for this test shall be capable of controlling the chamber temperature so that the module is maintained at specified temperatures, and the temperature can be continuously varied from a high temperature to a low temperature or vice versa at variable rate. The test chamber shall be so constructed that whole of the specimen is heated or cooled almost uniformly.

3. Preparation and mounting

The terminations of the module, being opened, shall be covered with an insulating tape of p.v.c. or the like to prevent corrosion, and the specimen shall be mounted on a position in the test chamber where it will not disturb the ventilation of chamber. A mini-module which has the same characteristics as those of the module to be tested may be used as the specimen.

4. Test procedures

The test procedures shall be as follows:

(1) Prior to the test of specimen, measure the electrical performances specified in 6.1 of JIS C 8918, and visually examine the appearance.
(2) Put the specimen into the chamber, maintain the specimen for 10 minutes or more in the chamber at a high temperature of 90°C $\pm$ 2°C and a low temperature of -40°C $\pm$ 3°C as shown in Annex 1 Fig. 1, and change the temperature from the high temperature to the low temperature and vice versa at a rate of 87°C per hour at the maximum. Count these operations as one cycle and carry out one cycle within 6 h. Unless otherwise specified, subject the specimen to 200 cycles continuously.
(3) After completion of the last cycle, allow the specimen to stand under the standard atmospheric conditions for 4 h to 16 h, then measure the electrical performances specified in (1) and visually examine the appearance.
(4) Monitor the module temperature continuously during the test by attaching a temperature sensor to a part of the specimen.

5. Items to be specified in detail specifications

The following items shall be specified in detail specifications:

(1) Initial measurement items (if necessary) [see 4 (1)]
(2) Final measurement items (if necessary) [see 4 (3)]

Specifically, first thing to do was making measurements of initial output of the solar cell modules. While the solar cell module was set at a predetermined position in a test chamber, the temperature in the test chamber was raised from -40°C to 90°C and reduced from 90°C to -40°C. This was counted as one cycle and total 200 cycles were carried out. The output of the solar cell module was again measured after the 200 cycles. A ratio (%) of the output after the 200 cycles to the initial output of the solar cell module (hereinafter referred to as output ratio to the initial output of the thermal cycling test) was calculated. It is specified that the acceptable output ratio to the initial output of the thermal cycling test is at least 95%.

[Dump heat steady state test]

The solar cell modules fabricated in Examples 1-1 to 1-5 and Comparative examples 1-1 to 1-5 were submitted to a dump heat steady state test. The dump heat steady state test was conducted in compliance with JIS C 8917:1998 Annex 11 (normative) Dump heat steady state test B-1. Specifically, first thing to do was making measurements of initial output of the solar cell modules. The solar cell modules were stored in a test chamber at a temperature of 85°C and a humidity of 85% or more for 1000 hours and then the outputs of the solar cell modules were measured again. A ratio (%) of the output after the 1000 hours to the initial output of the solar cell module (hereinafter referred to as output ratio to the initial output of the dump heat steady state test) was calculated. It is specified by JIS that the acceptable output ratio to the initial output of the dump heat steady state test is at least 95%.

[Evaluation test of insulation performance]

An evaluation test of insulation performance was conducted in compliance with an insulation resistance test in JIS C 8918:1998, 6 (Performance), (2). JIS C 8918:1998 specifies the test in Table 6 below.

[Table 6]

| Item | Performance | Test method |
|---|---|---|
| Insulation resistance | 100 M$\Omega$ or over | Short-circuit the output terminals of module and measure between these terminals and the frame or ground terminal by insulation resistance tester (1000 V mega) specified in JIS C 1302. |
| Dielectric withstand voltage | No abnormalities such as dielectric breakdown. | Short-circuit the output terminals of module and apply a d.c. voltage equal to two times of the maximum system voltage +1000 V between these terminals and the frame or ground terminal for 1 min. |
| Impulse voltage | No abnormalities such as flashover | Short-circuit the output terminals of module and apply a lightening impulse voltage of 4500 V (1.0 to 1.2 $\times$ 40 to 50 $\mu$s) between these terminals and the frame or ground terminal three times in each of positive polarity and negative polarity. |

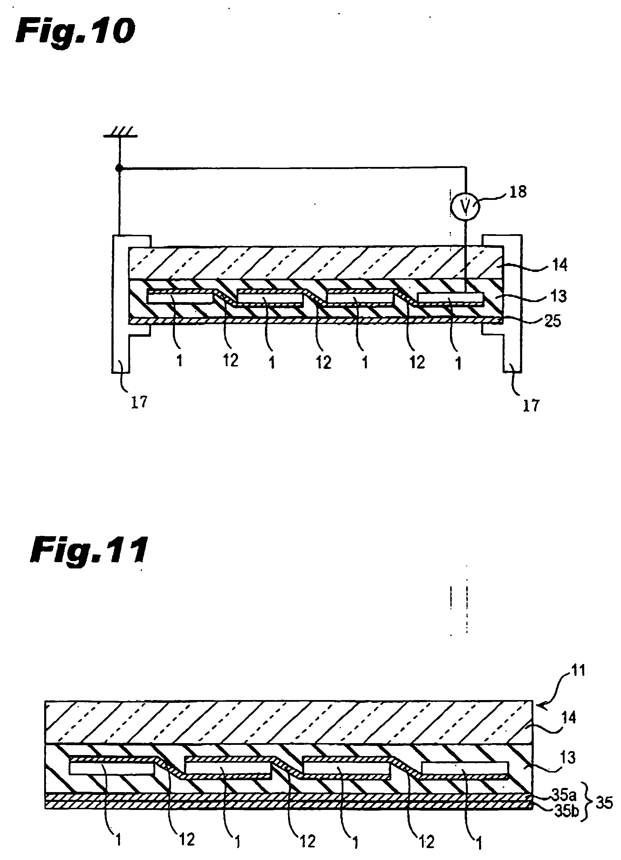

Since it is considered that the compound ratio of epoxy resin and urethane resin forming the collector electrodes 6 and 10 dose not effect the insulation performance, the evaluation test of insulation performance was conducted to the solar cell modules in Example 1-1 and Comparative example 1-1. Specifically, as shown in FIG. 10, a metal frame 17 was attached to a periphery of the solar cell module and resistance between the metal frame 17 and a predetermined solar cell element 1 in the solar cell module was measured by an insulation resistance tester (1000 V mega) 18. The test herein was conducted with the metal frame 17 grounded. If the resistance measured by the insulation resistance tester 18 was 1000 M$\Omega$ or more, it was judged that the module passed the test. If the resistance was less than 1000 M$\Omega$, it was judged that insulation failures occurred. In this evaluation test, 1000 solar cell modules of each Example 1-1 and Comparative example 1-1 were tested to calculate an incidence of such insulation failures.

Results of the thermal cycling test, the dump heat steady state test, and the evaluation test of insulation performance are shown in Table 7 below.

[Table 7]

| | Compound ratio of epoxy resin (vol.%) | Output ratio to initial output of thermal cycling test (%) | Output ratio to initial output of dump heat steady state test (%) (1000 hrs) | Insulation performance evaluation test (insulation failure incidence) (%) |
|---|---|---|---|---|
| Example 1-1 | 50 | 99 | 75 | 0 |
| Example 1-2 | 70 | 99 | 90 | - |
| Example 1-3 | 90 | 99 | 95 | - |
| Example 1-4 | 98 | 99 | 96 | - |
| Example 1-5 | 100 | 98 | 97 | - |

(continued)

|  | Compound ratio of epoxy resin (vol.%) | Output ratio to initial output of thermal cycling test (%) | Output ratio to initial output of dump heat steady state test (%) (1000 hrs) | Insulation performance evaluation test (insulation failure incidence) (%) |
|---|---|---|---|---|
| Comparative example 1-1 | 50 | 99 | 97 | 1 |
| Comparative example 1-2 | 70 | 99 | 98 | - |
| Comparative example 1-3 | 90 | 99 | 99 | - |
| Comparative example 1-4 | 98 | 99 | 99 | - |
| Comparative example 1-5 | 100 | 98 | 99 | - |

Table 7 shows that the output ratios to the initial output of the thermal cycling test of the solar cell modules in Examples 1-1 to 1-5 and Comparative examples 1-1 to 1-5 are 98% or more. That is, all modules of Examples 1-1 to 1-5 and Comparative examples 1-1 to 1-5 meet the acceptable criterion of the thermal cycling test, which is 95% or more. Therefore, it is found that the second solar cell modules using a single layer PET film as the rear surface protective member 15 (Examples 1-1 to1-5) (see FIG. 8) and the first solar cell modules using a three-layer structure of the PET layer 15a /the Al foil 1.5b / the PET layer 15c as the rear surface protective member 15 (Comparative example 1-1 to 1-5) (see FIG. 2) pass the thermal cycling test if the resin material for the collector electrodes 6 and 10 contains 50 vol.% to 100 vol.% epoxy resin (compound ratio of urethane resin: 50 vol.% to 0 vol. %).

From Table 7, it is found that the solar cell modules with the epoxy compound ratio of 100% (compound ratio of urethane: 0%) is less by 1% in the ratio to the initial output of the thermal cycling test (Example 1-5 and Comparative example 1-5: 98%) than the solar cell modules with the epoxy compound ratio of 50 vol.% to 98 vol.% (compound ratio of urethane: 50 vol.% to 2 vol.%) (Examples 1-1 to 1-4 and Comparative examples 1-1 to 1-4: 99%). The possible reason for this is epoxy resin is hard but brittle. When the resin material for the collector electrodes 6 and 10 contains 100 vol.% epoxy resin (compound ratio of urethane: 0 vol.%), the collector electrodes 6 and 10 of course become hard and brittle. In this case, cracking may occur in the finger portions 6a and 10a of the collector electrodes 6 and 10 because an expansion rate and a shrinkage rate of the collector electrodes 6 and 10 are becoming different from that of other parts of solar cell element 1 during the thermal cycling test. In the area where cracking occurred, resistance loss is generated and causes output reduction. For the reason, it is considered that Example 1-5 and Comparative example 1-5 have 1% less output ratio to the initial output than Examples 1-1 to 1-4 and Comparative examples 1-1 to 1-4.

Table 7 shows that the solar cell modules in Examples 1-3 to 1-5 have a ratio to the initial output of the dump heat steady test of 95% or more (Example 1-3: 95%, Example 1-4: 96%, Example 1-5: 97%), while the solar cell modules in Examples 1-1 and 1-2 have a ratio to the initial output of the dump heat steady test of 90% or less (Example 1-1: 75%, Example 1-2: 90%). That is, Examples 1-3 to 1-5 meet the acceptable criterion (output ratio to the initial output: 95% or more) of the dump heat steady test, but Examples 1-1 and 1-2 fail to meet the acceptable criterion. From the results, it is found that the solar cell modules using a single layer PET film (thickness: 30 $\mu$m, water vapor transmission rate: 15 g/m$^2$·24hrs (40°C, 90%)) as the rear surface protective member 25 (Examples 1-1 to 1-5) pass the dump heat steady test, if the resin material for the collector electrodes 6 and 10 contains 90 vol.% or more epoxy resin (compound ratio of urethane: 10 vol.% or less).

The possible reasons for the above mentioned results are as follows. In the case where the rear surface protective member 25 (see FIG. 8) is comprised of a single layer PET film (thickness: 30 $\mu$m, water vapor transmission rate: 15 g/m$^2$·24hrs (40°C, 90%)), a lot of water permeates into the solar cell module through the rear surface protective member 25. Because urethane resin is easy to be hydrolyzed, urethane resin contained in the collector electrodes 6 and 10 is hydrolyzed by the water entering the solar cell module, thereby deteriorating the collector electrodes 6 and 10. This deterioration increases contact resistance at interfaces between the collector electrode 6 and the light-transmitting conductive film 5 and between the collector electrode 10 and the light-transmitting conductive film 9, thereby reducing the output of the solar cell element 1. Therefore, the output from the solar cell module will be reduced. On the other hand, because epoxy resin is relatively not easy to be hydrolyzed in comparison with urethane resin, the collector electrodes 6 and 10 resist to be deteriorated with an increase in the compound ratio of epoxy resin in the resin material of the collector electrodes 6 and 10 and with a decrease in the compound ratio of urethane resin. The output of the solar cell module resists to be reduced with an increase in the compound ratio of epoxy resin in the resin material of the collector electrodes 6 and 10 and with a decrease in the compound ratio of urethane resin. For the above reason, the solar cell modules having a single layer PET film as the rear surface protective member 25 (Examples 1-1 to 1-5) are considered to have the ratio to the initial output of the dump heat steady test of 95% or more when the collector electrodes 6 and 10 contains 90 vol.% or more epoxy resin (compound ratio of urethane: 10 vol.% or less).

From Table 7, it is apparent that Comparative examples 1-1 to 1-5 meet the acceptable criterion (output ratio to the initial output: 95% or more) of the dump heat steady test (Comparative example 1-1: 97%, Comparative example 1-2: 98%, Comparative examples 1-3 to 1-5: 99%). The rear surface protective members 15 comprised of the three-layer structure of the PET layer 15a / Al foil 15b / the PET layer 15c (see FIG. 2) in Comparative examples 1-1 to 1-5 have a water vapor transmission rate of 0 $g/m^2 \cdot 24hrs$ (40°C, 90%), therefore water can hardly permeate into the solar cell module. For the reason, it is considered that the collector electrodes 6 and 10 are suffered little deterioration by hydrolysis.

Table 7 also shows that incidence of insulation failure of Example 1-1 is 0% in the evaluation test of insulation performance while 1% insulation failure occurred in the solar cell module of Comparative example 1-1. The possible reasons are as follows. The solar cell module of Comparative example 1-1 uses Al foil 15b in the rear surface protective member 15 (see FIG. 2). When soldering the connecting tab 12 to collector electrode 10 (see FIG. 1), the distance between solder of the tab 12 and the Al foil 15b may become smaller, resulting in reduction of withstand voltage between the solder and the Al foil 15b sometimes. For the reason, it is considered that the incidence of insulation failure is 1%. On the other hand, in Example 1-1, any metal materials such as Al foil are not used in the rear surface protective member 25 (see Fig. 8); there is no insulation failure. For this reason, it is considered that the incidence of insulation failure in Example 1-1 was 0%. As a consequence, it is concluded that the use of a rear surface protective member 25 without metal materials such as the Al foil is preferable to prevent yield reduction of the solar cell module caused by the insulation failure.

[Embodiment 2 of second solar cell module]

In the embodiment 2, in order to evaluate the moisture resistance according to water vapor transmission rate of a rear surface protective member in a solar cell module, various types of rear surface protective member are prepared to fabricate solar cell modules for Examples 2-1 to 2-25 and Comparative example 2-1. Each solar cell module was submitted to a dump heat steady test. Prior to the fabrication of the solar cell module, the water vapor transmission rate of the rear surface protective member of Examples 2-1 to 2-25 and Comparative example 2-1 was measured in the same method as the above-mentioned Example 1-1.

[Example 2-1]

In Example 2-1, a single layer PVF (polyvinyl fluoride) film (thickness: 30 $\mu$m, water vapor transmission rate: 30 $g/m^2 \cdot 24hrs$ (40°C, 90%)) is used as a rear surface protective member 25 (see FIG. 8). Also resin material containing 95 vol.% bisphenol-A epoxy resin and 5 vol.% urethane resin is used for the conductive paste (silver paste) to form the collector electrodes 6 and 10 (see FIG. 1). Except for this, the solar cell module of Example 2-1 is fabricated as in Example 1-1.

[Example 2-2] not falling under the claimed invention

In Example 2-2, resin material containing 98 vol.% bisphenol-A epoxy resin and 2 viol.% urethane resin is used for the conductive paste (silver paste) to form the collector electrodes 6 and 10. Except for this, the solar cell module of Example 2-2 is fabricated as in Example 2-1.

[Example 2-3] not falling under the claimed invention

In Example 2-3, resin material containing 100 vol.% bisphenol-A epoxy resin and 0 vol.% urethane resin is used for the conductive paste (silver paste) to form the collector electrodes 6 and 10. Except for this, the solar cell module of Example 2-3 is fabricated as in Example 2-1.

[Example 2-4]

In Example 2-4, a single layer PET film (thickness: 30 $\mu$m, water vapor transmission rate: 15 $g/m^2 \cdot 24hrs$ (40°C, 90%)) is used as a rear surface protective member 25 (see FIG. 8). Also resin material containing 80 vol.% bisphenol-A epoxy resin and 20 vol.% urethane resin is used for the conductive paste (silver paste) to form the collector electrodes 6 and 10 (see FIG. 1). Except for this, the solar cell module of Example 2-4 is fabricated as in Example 2-1.

[Example 2-5]

In Example 2-5, resin material containing 90 vol.% bisphenol-A epoxy resin and 10 vol.% urethane resin is used for the conductive paste (silver paste) to form the collector electrodes 6 and 10. Except for this, the solar cell module of Example 2-5 is fabricated as in Example 2-4.

[Example 2-6] not falling under the claimed invention

In Example 2-6, resin material containing 95 vol.% bisphenol-A epoxy resin and 5 vol.% urethane resin is used for the conductive paste (silver paste) to form the collector electrodes 6 and 10. Except for this, the solar cell module of Example 2-6 is fabricated as in Example 2-4.

[Example 2-7] not falling under the claimed invention

In Example 2-7, resin material containing 98 vol.% bisphenol-A epoxy resin and 2 vol.% urethane resin is used for the conductive paste (silver paste) to form the collector electrodes 6 and 10. Except for this, the solar cell module of Example 2-7 is fabricated as in Example 2-4.

[Example 2-8] not falling under the claimed invention

In Example 2-8, resin material containing 100 vol.% bisphenol-A epoxy resin and 0 vol.% urethane resin is used for the conductive paste (silver paste) to form the collector electrodes 6 and 10. Except for this, the solar cell module of Example 2-8 is fabricated as in Example 2-4.

[Example 2-9]

In Example 2-9, as shown in FIG. 11, a two-layer structure film of a PET layer 35a (thickness: 30 $\mu$m) / a PET layer 35b (thickness: 30 $\mu$m) (total thickness: 60 $\mu$m, water vapor transmission rate: 8 g/M$^2$·24hrs (40°C, 90%)) is used as a rear surface protective member 35. Note that the rear surface protective member 35 is one example of "protective layers* of the present invention. Also resin material containing 90 vol.% bisphenol-A epoxy resin and 10 vol.% urethane resin is used for the conductive paste (silver paste) to form the collector electrodes 6 and 10 (see FIG. 1). Except for this, the solar cell module of Example 2-9 is fabricated as in Example 2-1.

[Example 2-10]

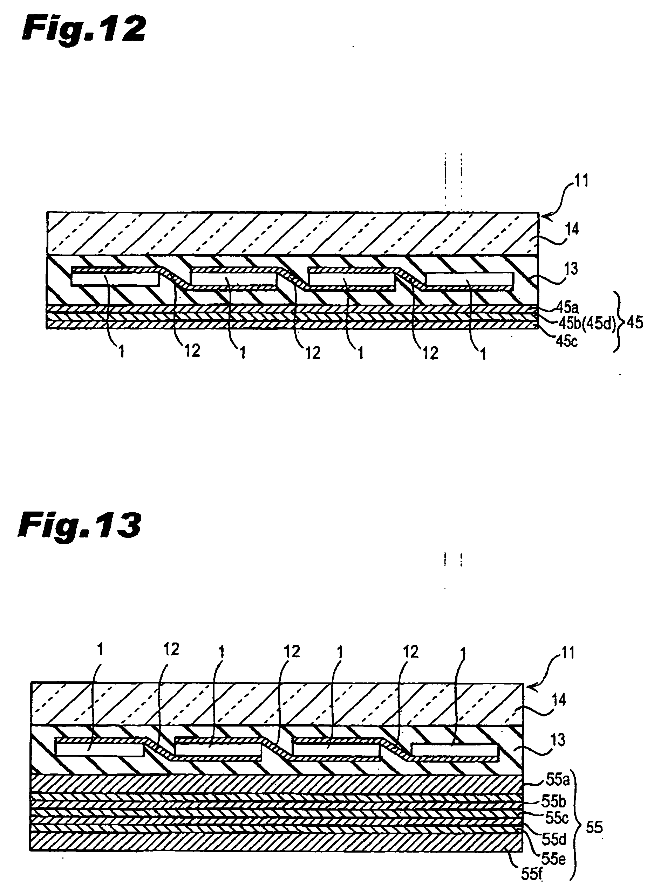

In Example 2-10, as shown in FIG. 12, a three-layer structure film of a PET layer 45a (thickness: 30 $\mu$m) / an SiO$_2$ layer 45b (thickness: 10 nm)/ a PET layer 45c (thickness: 30 $\mu$m) (total thickness: 60 $\mu$m, water vapor transmission rate: 1 g/m$^2$·24hrs (40°C, 90%)) is used as a rear surface protective member 45. Note that the rear surface protective member 45 is one example of "protective layers" in the present invention and the SiO$_2$ layer 45b is one example of "insulation layers" in the present invention. Also resin material containing 90 vol.% bisphenol-A epoxy resin and 10 vol.% urethane resin is used for the conductive paste (silver paste) to form the collector electrodes 6 and 10 (see FIG. 1). Except for this, the solar cell module of Example 2-10 is fabricated as in Example 2-1.

[Example 2-11] not falling under the claimed invention

In Example 2-11, resin material containing 95 vol.% bisphenol-A epoxy resin and 5 vol.% urethane resin is used for the conductive paste (silver paste) to form the collector electrodes 6 and 10. Except for this, the solar cell module of Example 2-11 is fabricated as in Example 2-10.

[Example 2-12] not falling under the claimed invention

In Example 2-12, resin material containing 98 vol.% bisphenol-A epoxy resin and 2 vol.% urethane resin is used for the conductive paste (silver paste) to form the collector electrodes 6 and 10. Except for this, the solar cell module of Example 2-12 is fabricated as in Example 2-10.

[Example 2-13] not falling under the claimed invention

In Example 2-13, resin material containing 100 vol.% bisphenol-A epoxy resin and 0 vol.% urethane resin is used for the conductive paste (silver paste) to form the collector electrodes 6 and 10. Except for this, the solar cell module of Example 2-13 is fabricated as in Example 2-10.

[Example 2-14]

In Example 2-14, the $SiO_2$ layer 45b (thickness: 10 $\mu$m) of the rear surface protective member 45 in Example 2-10 (see FIG. 12) is replaced with an $Al_2O_3$ layer 45d (thickness: 10 nm). Note that the $Al_2O_3$ layer 45d is one example of "insulation layers" in the present invention. In other words, a three-layer structure film of a PET layer 45a (thickness: 30 $\mu$m) / an $Al_2O_3$ layer 45d (thickness: 10 nm)/ a PET layer 45c (thickness: 30 $\mu$m) (total thickness: 60 $\mu$m, water vapor transmission rate: 1.5 g/m2·24hrs (40°C, 90%)) is used as a rear surface protective member.45. Also resin material containing 90 vol.% bisphenol-A epoxy resin and 10 vol.% urethane resin is used for the conductive paste (silver paste) to form the collector electrodes 6 and 10 (see FIG. 1). Except for this, the solar cell module of Example 2-14 is fabricated as in Example 2-1.

[Example 2-15]

In Example 2-15, the PET layer 45a in the rear surface protective member 45 of Example 2-10 (see FIG. 12) is increased in thickness. That is, a three-layer structure film of a PET layer 45a (thickness: 300 $\mu$m) / an $SiO_2$ layer 45b (thickness: 10 nm)/ a PET layer 45c (thickness: 30 $\mu$m) (total thickness: 330 $\mu$m, water vapor transmission rate: 0.1 g/m2·24hrs (40°C, 90%)) is used as a rear surface protective member 45. Also resin material containing 70 vol.% bisphenol-A epoxy resin and 30 vol.% urethane resin is used for the conductive paste (silver paste) to form the collector electrodes 6 and 10 (see FIG. 1). Except for this, the solar cell module of Example 2-15 is fabricated as in Example 2-1.

[Example 2-16]

In Example 2-16, resin material containing 80 vol.% bisphenol-A epoxy resin and 20 vol.% urethane resin is used for the conductive paste (silver paste) to form the collector electrodes 6 and 10. Except for this, the solar cell module of Example 2-16 is fabricated as in Example 2-15.

[Example 2-17]

In Example 2-17, resin material containing 90 vol.% bisphenol-A epoxy resin and 10 vol.% urethane resin is used for the conductive paste (silver paste) to form the collector electrodes 6 and 10. Except for this, the solar cell module of Example 2-17 is fabricated as in Example 2-15.

[Example 2-18] not falling under the claimed invention

In Example 2-18, as shown in FIG. 13, a six-layer structure film of a PET layer 55a (thickness: 300 $\mu$m) / an $SiO_2$ layer 55b (thickness: 10 nm)/ a PET layer 55c (thickness: 30 $\mu$m) / a PVDC (polyviaylidene fluoride) layer 55d (thickness: 30 $\mu$m) / an $SiO_2$ layer 55e (thickness: 10 nm)/ a PET layer 55f (thickness: 300 $\mu$m) (total thickness: 660 $\mu$m, water vapor transmission rate: 0.02 g/m2·24hrs (40°C, 90%)) is used as a rear surface protective member 55. Note that the rear surface protective member 55 is one example of "protective layers" in the present invention. Also resin material containing 60 vol.% bisphenol-A epoxy resin and 40 vol.% urethane resin is used for the conductive paste (silver paste) to form the collector electrodes 6 and 10 (see FIG. 1). Except for this, the solar cell module of Example 2-18 is fabricated as in Example 2-1.

[Example 2-19]

In Example 2-19, resin material containing 70 vol.% bisphenol-A epoxy resin and 30 vol.% urethane resin is used for the conductive paste (silver paste) to form the collector electrodes 6 and 10. Except for this, the solar cell module of Example 2-19 is fabricated as in Example 2-18.

[Example 2-20]

In Example 2-20, resin material containing 80 vol.% bisphenol-A epoxy resin and 20 vol.% urethane resin is used for the conductive paste (silver paste) to form the collector electrodes 6 and 10. Except for this, the solar cell module of Example 2-20 is fabricated as in Example 2-18.

[Example 2-21]

In Example 2-21, resin material containing 90 vol.% bisphenol-A epoxy resin and 10 vol.% urethane resin is used for the conductive paste (silver paste) to form the collector electrodes 6 and 10. Except for this, the solar cell module of Example 2-21 is fabricated as in Example 2-18.

[Example 2-22] not falling under the claimed invention

In Example 2-22, resin material containing 95 vol.% bisphenol-A epoxy resin and 5 vol.% urethane resin is used for the conductive paste (silver paste) to form the collector electrodes 6 and 10. Except for this, the solar cell module of Example 2-22 is fabricated as in Example 2-18.

[Example 2-23] not falling under the claimed invention

In Example 2-23, resin material containing 98 vol.% bisphenol-A epoxy resin and 2 vol.% urethane resin is used for the conductive paste (silver paste) to form the collector electrodes 6 and 10. Except for this, the solar cell module of Example 2-23 is fabricated as in Example 2-18.

[Example 2-24] not falling under the claimed invention

In Example 2-24, resin material containing 100 vol.% bisphenol-A epoxy resin and 0 vol.% urethane resin is used for the conductive paste (silver paste) to form the collector electrodes 6 and 10. Except for this, the solar cell module of Example 2-24 is fabricated as in Example 2-10.

[Example 2-25]

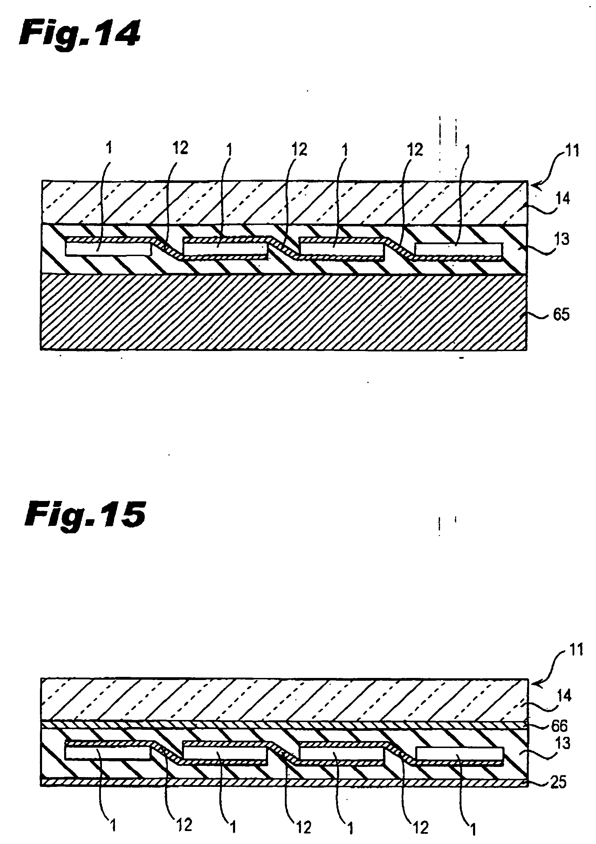

In Example 2-25, as shown in FIG. 14, a single layer PET film having substantially same thickness as the total thickness (660 $\mu$m) of the rear surface protective member 55 of Example 2-18 (see FIG. 13) (thickness: 660 $\mu$m, water vapor transmission rate: 1 g/m$^2$·24hrs (40°C, 90%)) is used as a rear surface protective member 65. Note that the rear surface protective member 65 is one example of "protective layers" in the present invention. Also resin material containing 90 vol.% bisphenol-A epoxy resin and 10 vol.% urethane resin is used for the conductive paste (silver paste) to form the collector electrodes 6 and 10 (see FIG. 1). Except for this, the solar cell module of Example 2-25 is fabricated as in Example 2-1.

[Comparative example 2-1]

In Comparative example 2-1, a solar cell module is fabricated as in Comparative example 1-3.

[Dump heat steady test]

The solar cell modules thus fabricated according to Examples 2-1 to 2-25 and Comparative example 2-1 were submitted to a dump heat steady test. The dump heat steady test was conducted for 1000 hours like the embodiment 1. In this test, in addition to the 1000-hour dump heat steady test conducted in the embodiment 1, a 2000-hour dump heat steady test was conducted to evaluate the moisture resistance (characteristic of maintaining the output against water vapor) for longer period of time. The 2000-hour dump heat steady test was conducted in a same manner as the above mentioned 1000-hour dump heat steady test, except for storing the solar cell module in a test chamber at a temperature of 85°C and a humidity of 85% for 2000 hours. Results of the test are shown in Table 8 below.

[Table 8]

| | Thicknes s of rear surface protective member (μm) | Water vapor transmission rate g/m²·24hrs (40°C, 90%)) | Compound ratio of epoxy resin (voL.%) | Output ratio to initial output of dump heat steady test (%) (1000 hrs) | Output ratio to initial output of dump heat steady test (%) (2000 hrs) |
|---|---|---|---|---|---|
| Example 2-1 | 30 | 30 | 95 | 94 | 90 |
| Example 2-2 | | | 98 | 95 | 92 |
| Example 2-3 | | | 100 | 96 | 93 |
| Example 2-4 | 30 | 15 | 80 | 93 | 87 |
| Example 2-5 | | | 90 | 95 | 90 |
| Example 2-6 | | | 95 | 95.5 | 92 |
| Example 2-7 | | | 98 | 96 | 93 |
| Example 2-8 | | | 100 | 97 | 94 |
| Example 2-9 | 60 | 8 | 90 | 96 | 93 |
| Example 2-10 | 60 | 1 | 90 | 96 | 94 |
| Example 2-11 | | | 95 | 97 | 95 |
| Example 2-12 | | | 98 | 97 | 96 |
| Example 2-13 | | | 100 | 98 | 96 |
| Example 2-14 | 60 | 1.5 | 90 | 96 | 94 |
| Example 2-15 | 330 | 0.1 | 70 | 93 | 90 |
| Example 2-16 | | | 80 | 95 | 93 |
| Example 2-17 | | | 90 | 97 | 95 |
| Example 2-18 | 660 | 0.02 | 60 | 93 | 90 |
| Example 2-19 | | | 70 | 95 | 93 |
| Example 2-20 | | | 80 | 96.5 | 94 |
| Example 2-21 | | | 90 | 98 | 95 |
| Example 2-22 | | | 95 | 98 | 95.5 |
| Example 2-23 | | | 98 | 99 | 96 |
| Example 2-24 | | | 100 | 100 | 97 |
| Example 2-25 | 660 | 1 | 90 | 96 | 92 |

(continued)

| | Thicknes s of rear surface protective member (μm) | Water vapor transmission rate g/m²·24hrs (40°C, 90%)) | Compound ratio of epoxy resin (voL.%) | Output ratio to initial output of dump heat steady test (%) (1000 hrs) | Output ratio to initial output of dump heat steady test (%) (2000 hrs) |
|---|---|---|---|---|---|
| Comparative example 2-1 | 90 | 0 | 90 | 99 | 98 |

From the results of the 1000-hour dump heat steady test shown in Table 8, it is apparent that in Examples 2-18 to 2-24 in which the rear surface protective member of the solar cell module has a water vapor transmission rate of 0.02 g/m²·24hrs (40°C, 90%), Examples 2-19 to 2-24 in which the resin material for forming the collector electrodes 6 and 10 contains 70 vol.% or more epoxy resin (compound ratio of urethane: 30 vol.% or less) has a ratio to the initial output of the dump heat steady test of 95% or more. It is also apparent that in Examples 2-15 to 2-17 in which the rear surface protective member of the solar cell module has a water vapor transmission rate of 0.1 g/m²·24hrs (40°C, 90%), Examples 2-16 to 2-17 in which the resin material for forming the collector electrodes 6 and 10 contains 80 vol.% or more epoxy resin (compound ratio of urethane: 20 vol.% or less) has a ratio to the initial output of the dump heat steady test of 95% or more. It is apparent that in Examples 2-10 to 2-13 in which the rear surface protective member of the solar cell module has a water vapor transmission rate of 1 g/m²·24hrs (40°C, 90%), Examples 2-10 to 2-13 in which the resin material for forming the collector electrodes 6 and 10 contains 90 vol.% or more epoxy resin (compound ratio of urethane: 10 vol.% or less) has a ratio to the initial output of the dump heat steady test of 96% or more. It is apparent that in Examples 2-4 to 2-8 in which the rear surface protective member of the solar cell module has a water vapor transmission rate of 15 g/m²·24hrs (40°C, 90%), Examples 2-5 to 2-8 in which the resin material for forming the collector electrodes 6 and 10 contains 90 vol.% or more epoxy resin (compound ratio of urethane: 10 vol.% or less) has a ratio to the initial output of the dump heat steady test of 95% or more. It is also apparent that in Examples 2-1 to 2-3 in which the rear surface protective member of the solar cell module has a water vapor transmission rate of 30 g/m²·24hrs (40°C, 90%), Examples 2-2 to 2-3 in which the resin material for forming the collector electrodes 6 and 10 contains 98 vol.% or more epoxy resin (compound ratio of urethane: 2 vol.% or less) has a ratio to the initial output of the dump heat steady test of 95% or more. From these results, the following are found. With a gradual increase in the water vapor transmission rate of the rear surface protective member from 0.02 g/m²·24hrs (40°C, 90%) to 30 g/m²·24hrs (40°C, 90%), more water permeates into the solar cell module. If a content of epoxy resin in the resin material for the collector electrodes 6 and 10 is increased from 70 vol.% to 98 vol.% with the increase in the water vapor transmission rate of the rear surface protective member, the solar cell module meets the acceptable criterion (ratio to the initial output: 95% or more) of the 1000-hour dump heat steady test. If a content of epoxy resin in the resin material for the collector electrodes 6 and 10 is increased to 98 vol.% or more when the water vapor transmission rate of the rear surface protective member is 30 g/m²·24hrs (40°C, 90%) or less, the solar cell module meets the acceptable criterion (ratio to the initial output: 95% or more) of the 1000-hour dump heat steady test. If a content of epoxy resin in the resin material for the collector electrodes 6 and 10 is increased to 90 vol.% or more when the water vapor transmission rate of the rear surface protective member is 15 g/m²·24hrs (40°C, 90%) or less, the solar cell module meets the acceptable criterion (ratio to the initial output: 95% or more) of the 1000-hour dump heat steady test.

From the results of the 2000-hour dump heat steady test shown in Table 8, it is apparent that in Examples 2-18 to 2-24 in which the rear surface protective member of the solar cell module has a water vapor transmission rate of 0.02 g/m²·24hrs (40°C, 90%), Examples 2-21 to 2-24 in which the resin material for forming the collector electrodes 6 and 10 contains 90 vol.% or more epoxy resin (compound ratio of urethane: 10 vol.% or less) has a ratio to the initial output of the dump heat steady test of 95% or more. It is also apparent that in Examples 2-15 to 2-17 in which the rear surface protective member of the solar cell module has a water vapor transmission rate of 0.1 g/m²·24hrs (40°C, 90%), Example 2-17 in which the resin material for forming the collector electrodes 6 and 10 contains 90 vol.% or more epoxy resin (compound ratio of urethane: 10 vol.% or less) has a ratio to the initial output of the dump heat steady test of 95% or more. It is apparent that in Examples 2-10 to 2-13 in which the rear surface protective member of the solar cell module has a water vapor transmission rate of 1 g/m²·24hrs (40°C, 90%), Examples 2-11 to 2-13 in which the resin material for forming the collector electrodes 6 and 10 contains 95 vol.% or more epoxy resin (compound ratio of urethane: 5 vol.% or less) has a ratio to the initial output of the dump heat steady test of 95% or more. It is apparent that in Examples 2-4 to 2-8 in which the rear surface protective member of the solar cell module has a water vapor transmission rate of 15 g/m²·24hrs (40°C, 90%), even Example 2-8 in which the resin material for forming the collector electrodes 6 and 10 contains 100 vol.% epoxy resin (compound ratio of urethane: 0 vol.%) has a ratio to the initial output of the dump heat steady test of 94% . It is also apparent that in Examples 2-1 to 2-3 in which the rear surface protective member of the solar cell module has a water vapor transmission rate of 30 g/m²·24hrs (40°C, 90%), even Example 2-3 in which the resin material for forming the collector electrodes 6 and 10 contains 100 vol.% epoxy resin (compound ratio of urethane: 0 vol.%) has a ratio to the initial output of the dump heat steady test of 93%. Consequently, in the case where the water vapor transmission rate of the rear surface protective member is 1 g/m$^2$·24hrs (40°C, 90%), the solar cell modules can have the ratio to the initial output of 95% or more after the 2000-hour dump heat steady test by using the resin material for the collector electrodes 6 and 10 containing 95 vol.% or more epoxy resin. Therefore it is preferable to contain 95 vol.% or more epoxy resin in the resin material for the collector electrodes 6 and 10 in order to obtain excellent moisture resistance (characteristic of maintaining the output against the water vapor) over a longer period of time.

Table 8 shows the solar cell module of Example 2-9 in which the rear surface protective member is the two-layer structure film of the PET layer (thickness: 30 $\mu$m) / the PET layer (thickness: 30 $\mu$m) has the ratio to the initial output of 96% after the 1000-hour dump heat steady test and of 93% after the 2000-hour dump heat steady test. These values are larger than the ratio to the initial output of 95% after the 1000-hour dump heat steady test and of 90% after the 2000-hour dump heat steady test of the solar cell module of Example 2-5 in which the rear surface protective member is a single layer PET film (thickness: 30$\mu$m). This may be because the rear surface protective member of Example 2-9 has the lower water vapor transmission rate (8 g/m$^2$·24hrs (40°C, 90%)) than the water vapor transmission rate of Example 2-5 (15 g/m$^2$·24hrs (40°C, 90%)). Thus it is found that even the PET layer having relatively high water vapor transmission rate (thickness: 30 $\mu$m, water vapor transmission rate: 15 g/m$^2$·24hrs (40°C, 90%)) can be reduced its water vapor transmission rate by laminating the two PET layers to increase the thickness like Example 2-9 (see FIG. 11) and can be used as a rear surface protective member. Therefore it can be concluded that the use of the two-layer structure PET film as a rear surface protective member improves the moisture resistance (characteristic of maintaining the output against water vapor) of the solar cell module.

Table 8 also shows the solar cell modules of Examples 2-10 and 2-14 have the ratio to the initial output after the 2000-hour dump heat steady test of 94%. These values are larger than the ratio to the initial output after the 2000-hour dump heat steady test of the solar cell module of Example 2-9 (93%). This may be because the rear surface protective member of Example 2-10 and 2-14 have the lower water vapor transmission rate (Example 2-10: 1 g/m$^2$·24hrs (40°C, 90%), Example 2-14: 1.5 g/m$^2$·24hrs (40°C, 90%)) than the water vapor transmission rate of Example 2-9 (8 g/m$^2$·24hrs (40°C, 90%)). Consequently, it is obvious that the rear surface protective member comprised of an insulation layer such as the $SiO_2$ layer or the $Al_2O_3$ layer having a low water vapor transmission rate sandwiched between the two PET layers (Examples 2-10 and 2-14) can have the lower water vapor transmission rate than the rear surface protective member comprised of only two PET layers (Example 2-9). Also it is found that the use of the rear surface protective member having a structure of the PET layer / the $SiO_2$ layer/ the PET layer or the PET layer / the $Al_2O_3$ layer / the PET layer can improve the moisture resistance (characteristic of maintaining the output against water vapor) of the solar cell module. Besides, because the $SiO_2$ layer and the $Al_2O_3$ layer are insulation layers, the insulation failure will not occur even if the distance between solder of the connecting tab 12 for connecting the tab 12 to the collector electrode 10 of the solar cell element 1 and the $SiO_2$ layer or the $Al_2O_3$ becomes small. This can prevent yield reduction of the solar cell module caused by the insulation failure.

Table 8 shows the solar cell module of Example 2-17 has the ratio to the initial output of 97% after the 1000-hour dump heat steady test and of 95% after the 2000-hour dump heat steady test. These values are larger than the ratio to the initial output of 96% after the 1000-hour dump heat steady test and of 94% after the 2000-hour dump heat steady test of the solar cell module of Example 2-10. This may be because the rear surface protective member of Example 2-17 has the lower water vapor transmission rate (0.1 g/m$^2$·24hrs (40°C, 90%)) than the water vapor transmission rate of Example 2-10 (1 g/m$^2$·24hrs (40°C, 90%)). From the results, it is found that when using a rear surface protective member having a three-layer structure of the PET layer / the $SiO_2$ layer / the PET layer, the rear surface protective member of Example 2-17 with one PET layer increased in thickness to 300 $\mu$m can have a lower water vapor transmission rate than Example 2-10 with both PET layers remained 30 $\mu$m. Therefore, the use of the rear surface protective member comprised of the PET layer, which is increased in thickness, (thickness: 300 $\mu$m) / the $SiO_2$ layer (thickness: 10 nm) / the PET layer (thickness: 30 $\mu$m) of Example 2-17 can improve the moisture resistance (characteristic of maintaining the output against water vapor) of the solar cell module in comparison with Example 2-10.

Table 8 shows the solar cell module of Example 2-21 has the ratio to the initial output after the 1000-hour dump heat steady test (98%) and after the 2000-hour dump heat steady test (95%). These values are larger than the ratio to the initial output after the 1000-hour dump heat steady test (97%) and after the 2000-hour dump heat steady test (95%) of the solar cell module of Example 2-17. This may be because the rear surface protective member of Example 2-21 has the smaller water vapor transmission rate (0.02 g/m$^2$·24hrs (4.0°C, 90%)) than the water vapor transmission rate of Example 2-17 (0.1 g/m$^2$·24hrs (40°C, 90%)). Thus it is found that the rear surface protective member having a six-layer structure (Example 2-21) formed by laminating a three-layer structure film of a PVDC layer (thickness: 30 $\mu$m) / an $SiO_2$ layer (thickness: 10 nm)/ a PET layer (thickness: 300 $\mu$m) on a three-layer structure film of a PET layer (thickness: 300 $\mu$m) / an $SiO_2$ layer (thickness: 10 nm))/ a PET layer (thickness: 30 $\mu$m) (Example 2-17) can have a lower water vapor transmission rate than the rear surface protective member having a three-layer structure film of a PET layer (thickness: 300 $\mu$m) / an $SiO_2$ layer (thickness: 10 nm)/ a PET layer (thickness: 30 $\mu$m) (Example 2-17). Therefore, the use of the six-layer structure rear surface protective member of Example 2-21 can improve the moisture resistance (characteristic of maintaining the output against water vapor) of the solar cell module in comparison with the three-layer structure rear surface protective member of Example 2-17.

Table 8 shows the solar cell module of Example 2-25 has the ratio to the initial output after the 1000-hour dump heat steady test (96%) and after the 2000-hour dump heat steady test (92%). These values are lower than the ratio to the initial output after the 1000-hour dump heat steady test (98%) and after the 2000-hour dump beat steady test (95%) of the solar cell module of Example 2-21. This may be because the rear surface protective member of Example 2-25 has the higher water vapor transmission rate (1 $g/m^2 \cdot 24hrs$ (40°C, 90%)) than the water vapor transmission rate of Example 2-21 (0.02 $g/m^2 \cdot 24hrs$ (40°C, 90%)). Thus it is found that in comparison with the rear surface protective member having a six-layer structure of the PET layer (thickness: 300 $\mu$m) / the $SiO_2$ layer (thickness: 10 nm)/ the PET layer (thickness: 30 $\mu$m) / the PVDC layer (thickness: 30 $\mu$m) / the $SiO_2$ layer (thickness: 10 nm)/ the PET layer (thickness: 300 $\mu$m) (Example 2-21), the single layer PET film having the same thickness as the total thickness: (660 $\mu$m) of the six-layer structure rear surface protective member (Example 2-25) has a higher water vapor transmission rate. It is also found the use of the rear surface protective member comprised of the single layer PET film having the same thickness as the six-layer structure rear surface protective member (Example 2-25) can not improve the moisture resistance (characteristic of maintaining the output against water vapor) of the solar cell module as much as the six-layer structure rear surface protective member of Example 2-21.

Table 8 shows the solar cell module of Comparative example 2-1 has the ratio to the initial output after the 1000-hour dump heat steady test (99%) and after the 2000-hour dump heat steady test (98%). Each solar cell module of Examples 2-5, 2-9, 2-10, 2-14, 2-17, 2-21 and 2-25 has a lower output ratio to the initial output after the 1000-hour dump heat steady test (95% to 98%) and after the 2000-hour dump heat steady test (90% to 95%) than that of Comparative example 2-1. This may be because the rear surface protective member of Comparative example 2-1 has the water vapor transmission rate of 0 $g/m^2 \cdot 24hrs$ (40°C, 90%), therefore water vapor is substantially not able to permeate through the rear surface protective member. However, as apparent from the results (see Table 1) of the evaluation test of insulation performance according to the embodiment 1, in the case of the solar cell module using the rear surface protective member comprised of the PET layer (thickness: 30 $\mu$m) / the Al foil (thickness: 30 $\mu$m) / the PET layer (thickness: 30 $\mu$m) (in the case of Comparative example 2-1), yield of the solar cell module could be reduced for the insulation failure. Therefore it is obvious that the rear surface protective member comprised of the PET layer (thickness: 30 $\mu$m) / the Al foil (thickness: 30 $\mu$m) / the PET layer (thickness: 30 $\mu$m) of Comparative example 2-1 is not preferable.

[Embodiment 3 of the second solar cell module]

In the embodiment 3 of the second solar cell module, solar cell modules according to Examples 3-1 to 3-6 are fabricated, each having a structure to limit the influence of sodium that is diffused with water permeation. An evaluation was made regarding the influence of sodium leached out of a front surface protective member (glass substrate) on the output characteristics with the use of the fabricated solar cell modules.

[Example 3-1]

In Example 3-1, a solar cell module is fabricated as in Example 2-2. That is, in Example 3-1, resin material containing 90 vol.% bisphenol-A epoxy resin and 10 vol.% urethane resin is used for conductive paste (silver paste) to form the collector electrodes 6 and 10. A single layer PET film (thickness: 30 $\mu$m, water vapor transmission rate: 15 $g/m^2 \cdot 24hrs$ (40°C, 90%)) is used as a rear surface protective member 25 (see FIG. 8). A soda glass containing about 15 wt.% sodium is used as the front surface protective member 14. Note that the front surface protective member 14 is one example of "sodium-containing members" in the present invention.

[Example 3-2]

In Example 3-2, as shown in FIG. 15, a sodium blocking layer 66, which is an $SiO_2$ layer and has a thickness of 100 nm, is formed on a lower surface of the front surface protective member 14 by sputtering. Except for this, the solar cell module of Example 3-2 is fabricated as in Example 3-1.

[Example 3-3]

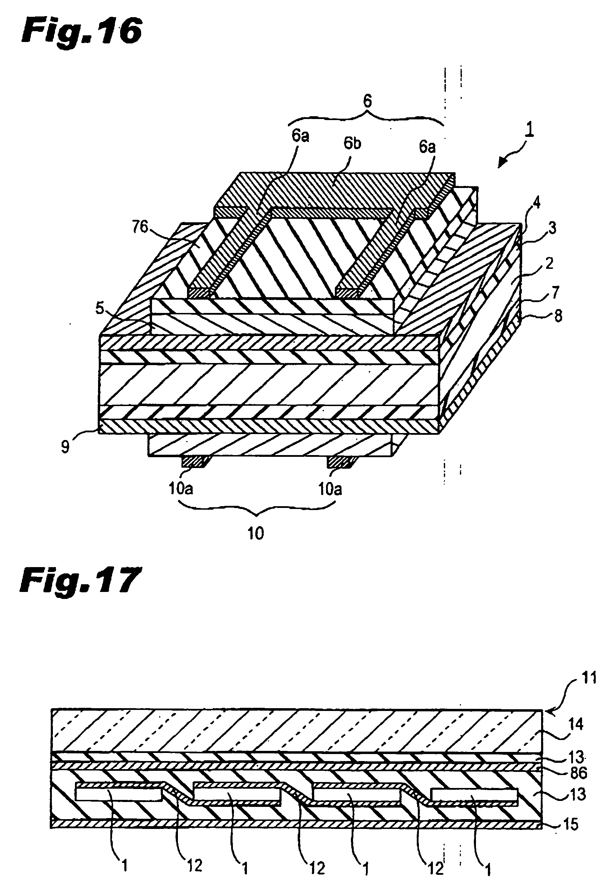

In Example 3-3, as shown in FIG. 16, a sodium blocking layer 76, which is an $SiO_2$ layer and has a thickness of 100 nm, is formed on a surface, which is closer to the front surface protective member 14, of a light-transmitting conductive film 5 (see FIG. 2) of the solar cell element 1 by sputtering. Except for this, the solar cell module of Example 3-3 is fabricated as in Example 3-1.

[Example 3-4]

In Example 3-4, as shown in FIG. 17, a sodium blocking layer 86, which is a single layer PET film and has a thickness of 150 $\mu$m, and sealant 13 are subsequently deposited between the solar cell element 1 and the front surface protective member 14. Except for this, a solar cell module of Example 3-4 is fabricated as in Example 3-1.

[Example 3-5]

In Example 3-5, the solar cell element 1 (see FIG. 1) is turned upside down and placed in a solar cell module. In other words, the solar cell element 1 is placed so that a p-type amorphous silicon layer 4 is positioned on a surface, which is remote from the front surface protective member 14 (see FIG. 8), of an n-type single crystal silicon substrate 2, and an n-type amorphous silicon layer 8 (see FIG. 1) is positioned on another surface, which is adjacent to the front surface protective member 14(see FIG. 8), of the n-type single crystal silicon substrate 2. Except for this, the solar cell module of Example 3-5 is fabricated as in Example 3-1. Note that the n-type single crystal silicon substrate 2 is one example of "n-type semiconductor layers" in the present invention and the p-type amorphous silicon layer 4 is one example of "p-type semiconductor layers" in the present invention.

[Example 3-6]

In Example 3-6, as shown in FIG. 18, a three-layer structure film of a PET layer 45a (thickness: 30 $\mu$m) / an $SiO_2$ layer 45b (thickness: 10 nm)/ a PET layer 45c (thickness: 30 $\mu$m) (total thickness: 60 $\mu$m, water vapor transmission rate: 1 g/m$^2$·24hrs (40°C, 90%)) is used as a rear surface protective member 45. A sodium blocking layer 66, which is an $SiO_2$ layer and has a thickness of 100 nm, is formed on the lower surface of the front surface protective member 14 by sputtering. Except for this, the solar cell module of Example 3-6 is fabricated as in Example 3-1.

[Evaluation test of influence of sodium from front surface protective member]

The fabricated solar cell modules of Examples 3-1 to 3-6 were submitted to an evaluation test of influence of sodium from the front surface protective member. The evaluation test was conducted in a same manner as the 1000-hour dump heat steady test and the 2000-hour dump heat steady test conducted in the embodiment 2. Results of the test are shown in Table 9 below.

[Table 9]

| | Output ratio to the initial output of evaluation test on influence of sodium (%) (1000 hours) | Output ratio to the initial output of evaluation test on influence of sodium (%) (2000 hours) |
|---|---|---|
| Example 3-1 | 95 | 90 |
| Example 3-2 | 97 | 95 |
| Example 3-3 | 97 | 95 |
| Example 3-4 | 97 | 95 |
| Example 3-5 | 97 | 95 |
| Example 3-6 | 98 | 96 |

The results of the 1000-hour evaluation test of the sodium influence shown in Table 9 indicate that the ratio to the initial output of the solar cell module of Examples 3-2 to 3-5 (97%) is higher than that of Example 3-1 (95%) by 2%. The results of the 2000-hour evaluation test of the sodium influence shown in Table 9 indicate that the ratio to the initial output of the solar cell module of Examples 3-2 to 3-5 (95%) is higher than that of Example 3-1 (90%) by 5%.

The possible reasons for the results are as follow. Because the solar cell module of Examples 3-1 to 3-5 uses the single layer PET film (thickness: 30 $\mu$m, water vapor transmission rate: 15 g/m$^2$·24hrs (40°C, 90%)) as the rear surface protective member 15, a lot of water permeates the solar cell module through the rear surface during the evaluation test. When the water reaches the front surface protective member 14 comprised of a soda glass (sodium content: about 15 wt.%), sodium in the front surface protective member 14 is leached out into water and the water with the sodium diffuses within the solar cell module. In the case of Example 3-1, the sodium reaches the solar cell element 1 (see FIG. 1), because there is no sodium blocking layer to prevent sodium permeation. Thus the sodium causes deterioration of the p-type amorphous silicon layer 4 of the solar cell element 1 and makes p-type impurities in the p-type amorphous silicon layer 4 inactive, thereby reducing the output of the solar cell element 1.

On the other hand, because the sodium blocking layer 66 comprised of the $SiO_2$ layer is provided on the lower surface of the front surface protective member 14 in Example 3-2 (see FIG. 15) and the sodium blocking layer 86 comprised of the single layer PET film is provided between the front surface protective member 14 and solar cell element 1 of Example 3-4 (see FIG. 17), the sodium is prevented from reaching the solar cell element 1 by the sodium blocking layer 66 and 86. Thus, the sodium is prevented from reaching the p-type amorphous silicon layer 4 (see FIG. 1). In the case of Example 3-3 (see FIG. 16), because the sodium blocking layer 76 comprised of the $SiO_2$ layer is formed on the surface, which is close to the front surface protective member 14, of the light-transmitting conductive film 5 of the solar cell element 1 (see FIG. 2), the sodium reaches the solar cell element 1, but not reach the p-type amorphous silicon layer 4. In the case of Example 3-5, the p-type amorphous silicon layer 4 is positioned on the surface, which is remote from the front surface protective member 14, of the n-type single crystal silicon substrate 2 (see FIG. 2), the distance between the p-type amorphous silicon layer 4 and the front surface protective member 14 becomes larger than that of the solar cell module whose p-type amorphous silicon layer 4 is positioned on the surface, which is close to the front surface protective member 14, of the n-type single crystal silicon substrate 2. Consequently, sodium is prevented from reaching the p-type amorphous silicon layer 4 in Example 3-5. For the reason, it is considered that the deterioration of the p-type amorphous silicon layer 4 and the inactivation of p-type impurities in the p-type amorphous silicon layer 4 caused by sodium are prevented in Examples 3-2 to 3-5. As a result, the solar cell modules in Examples 3-2 to 3-5 can avoid the output reduction in the evaluation test, therefore it is considered that the output ratios to the initial output of Examples 3-2 to 3-5 are higher than that of Example 3-1.

From Table 9, it is found that the solar cell module using a single layer PET film having relatively high water vapor transmission rate (thickness: 30 $\mu$m, water vapor transmission rate: 15 g/m$^2$·24hrs (40°C, 90%)) as the rear surface protective member 15 can meet the acceptable criterion of the 1000-hour evaluation test (moisture resistance test) (output ratio to the initial output: 95% or more) and can obtain the ratio to the initial output of 95% or more after the 2000-hour evaluation test (moisture resistance test) if the solar cell module is comprised so as to stop the sodium reaching the p-type amorphous silicon layer 4 of the solar cell element 1, like Examples 3-2 to 3-5.

The results of the 1000-hour evaluation test shown in Table 9 indicate that the ratio to the initial output of the solar cell module of Example 3-6 (98%) is higher than that of Example 3-2 (97%) by 1%. The results of the 2000-hour evaluation test shown in Table 9 indicate that the ratio to the initial output of the solar cell module of Example 3-6 (96%), which uses a sodium blocking layer on the lower surface of the surface protective member and a rear surface protective member of the PET layer (thickness: 30 $\mu$m) / the $SiO_2$ layer (thickness: 10 nm) / the PET layer (thickness: 30 $\mu$m), is higher than that of Example 3-2 (95%), which uses a sodium blocking layer on the lower surface of the front surface protective member and a single layer PET film (thickness. 30 $\mu$m) as the rear surface protective member, by 1%. The possible reasons are as follows. The rear surface protective member 45 of Example 3-6 (see FIG. 18) has a lower water vapor transmission rate (1 g/m$^2$·24hrs (40°C, 90%)) than that of the rear surface protective member 15 of Example 3-2 (15 g/m$^2$·24hrs (40°C, 90%)) (see FIG. 2). Thus less water permeates within the solar cell module of Example 3-6 in comparison with Example 3-2. For the reason, it is considered that the output ratios to the initial outputs after the 1000-hour and 2000-hour evaluation tests are high. It can be concluded that the formation of the sodium blocking layer on the lower surface of the front surface protective member and the use of the rear surface protective member having a low water vapor transmission rate are preferable to improve the ratio to the initial output.

Bisphenol-A epoxy resin is used as epoxy resin contained in a resin material of collector electrodes in the above embodiments, but the resin material of the present invention is not limited to this and can be other type of epoxy resin including: epoxy resin derived from bifunctional compounds based on stilbene and biphenyl; epoxy resin derived from polyfunctional compounds based on polyphenol and phenol novolac; and epoxy resin derived from polyaddition product based on dicyclopentadiene or phenol. These types of epoxy resin also can obtain the same effect as in the above embodiments.

In the above embodiments, silver (Ag) is used as conductive filler contained in the conductive paste to form collector electrodes. The filler of the present invention is not limited to this and can be any other conductive materials including: metal such as copper, nickel and aluminum and carbon.

In the above embodiments, descriptions were made taking solar cell modules using solar cell elements having an HIT structure on both sides as examples. The present invention is not limited to this, but is applicable to solar cell modules using various kinds of solar cell elements such as a single crystal silicon solar cell element, a polycrystalline silicon solar cell element, a thin film silicon solar cell element, a compound semiconductor solar cell element, a dye-sensitized solar cell element and an organic solar cell element.

In the embodiment 2 of the second solar cell module, an $SiO_2$ layer and an $Al_2O_3$ layer are used for the rear surface protective layer serving as an insulation layer having a function of reducing water permeation. The rear surface protective layer of the present invention is not limited to this and can be any other insulation layers having a function of reducing water permeation including: any oxide insulation layers except for the $SiO_2$ layer and the $Al_2O_3$ layer, and

organic acid films.

In the embodiment 3 of the second solar cell module, the sodium blocking layer is made of an $SiO_2$ layer. The sodium blocking layer in the present invention is not limited to this, but can be other layers including a nitride layer and fluoride layer if only they have sodium blocking effect. For example, the sodium blocking layer may be comprised of an SiN film, an $MgF_2$ film, and/or a $TiO_2$ film. The sodium blocking layer comprised of these materials also can obtain the same effect as in the above embodiments.

Although the present invention has been described and illustrated in detail, it should be clearly understood that the description discloses examples of different embodiments of the invention and is not intended to be limited to the examples or illustrations provided.

**Claims**

1. A solar cell module in which a plurality of solar cell elements are disposed between a front surface member and a rear surface protective member, and col-lector electrodes of the solar cell elements are electrically connected to each other by connecting tabs, wherein
the connecting tabs are soldered to the collector electrodes with Sn-Ag-Cu solder,
the collector electrodes are comprised of electrically-conductive paste containing thermosetting resin and electrically-conductive powder, and
the thermosetting resin consists of epoxy resin and urethane resin, and contains 70% to 90% by volume epoxy resin having a glass transition temperature of 80 °C to 200 °C, the glass transition temperature being measured by a Thermomechanical Analysis, TMA, method.

2. The solar cell module according to claim 1, wherein the epoxy resin has a glass transition temperature of 90 °C to 200 °C measured by the TMA method.

3. The solar cell module according to claim 1, wherein the electrically-conductive powder to be mixed in the electrically-conductive paste includes approximately granulated electrically-conductive filler and flaky electrically-conductive filler, and a content of the approximately granulated electrically-conductive filler to total weight of both conductive fillers is 40 wt.% to 80 wt.%

4. The solar cell module according to claim 1, wherein the rear surface protective member has a multilayer structure with a metal thin film sandwiched between resin layers.

5. The solar cell module according to claim 1, wherein the water vapor transmission rate of the rear surface protective member is 15 g/m²·24hrs (40 °C, 90%) or less, and the thermosetting resin contains 90 vol.% epoxy resin.

6. The solar cell module according to claim 1, wherein the water vapor transmission rate of the rear surface protective member is 0.1 g/m²·24hrs (40 °C, 90%) or less, and the thermosetting resin contains 80 vol.% or more epoxy resin.

7. The solar cell module according to claim 1, wherein the water vapor transmission rate of the rear surface protective member is 0.02 g/m²·24hrs (40 °C, 90%) or less, and the thermosetting resin contains 70 vol.% or more epoxy resin.

8. The solar cell module according to claim 1, wherein the rear surface protective member includes an insulation layer comprised of either silicon oxide or metal oxide.

9. The solar cell module according to claim 1, wherein the rear surface protective member includes layers comprised of resin materials but not metal materials.

10. The solar cell module according to claim 1, wherein the front surface member is comprised of materials containing sodium, and a sodium blocking layer for preventing sodium permeation is provided between the front surface member and the solar cell element.

11. The solar cell module according to claim 1, wherein the front surface member is comprised of materials containing sodium, and a sodium blocking layer for preventing sodium permeation is provided on a surface, which is adjacent to the front surface member, of the solar cell element.

**Patentansprüche**

1.  Solarzellenmodul, in dem eine Anzahl von Solarzellen zwischen einem Vorderoberflächenelement und einem Rückoberflächenschutzelement angeordnet sind und Kollektorelektroden der Solarzellenelemente miteinander durch Verbindungsstreifen verbunden sind, wobei
    die Verbindungsstreifen mit Sn-Ag-Cu-Lot an die Kollektorelektroden gelötet sind,
    die Kollektorelektroden aus elektrisch leitender Paste gebildet sind, die aushärtbares Harz und elektrisch leitendes Pulver enthält, und
    das aushärtbare Harz aus Epoxyharz und Urethanharz besteht und 70 bis 90 Volumenprozent Epoxyharz mit einer Glasübergangstemperatur von 80 °C bis 200 °C enthält, wobei die Glasübergangstemperatur durch ein thermomechanisches Analyse, TMA, Verfahren gemessen wird.

2.  Solarzellenmodul gemäß Anspruch 1, wobei das Epoxyharz eine Glasübergangstemperatur von 90 °C bis 200 °C, gemessen durch das TMA-Verfahren, aufweist.

3.  Solarzellenmodul gemäß Anspruch 1, wobei das elektrisch leitende Pulver, das in die elektrisch leitende Paste zu mischen ist, ungefähr granuliertes elektrisch leitendes Füllmittel und schuppiges elektrisch leitendes Füllmittel einschließt, und ein Gehalt des ungefähr granulierten elektrisch leitenden Füllmittels zu einem Gesamtgewicht beider leitender Füllmittel 40 Gewichtsprozent bis 80 Gewichtsprozent beträgt.

4.  Solarzellenmodul gemäß Anspruch 1, wobei das Rückoberflächenschutzelement eine Mehrschichtstruktur mit einer Metalldünnschicht, die zwischen Harzschichten eingelegt ist, aufweist.

5.  Solarzellenmodul gemäß Anspruch 1, wobei die Wasserdampftransmissionsrate des Rückoberflächenschutzelements 15 g/m$^2$·24 h (40 °C, 90 %) oder weniger beträgt, und das aushärtbare Harz 90 Volumenprozent oder mehr Epoxyharz enthält.

6.  Solarzellenmodul gemäß Anspruch 1, wobei die Wasserdampftransmissionsrate des Rückoberflächenschutzelements 0,1 g/m$^2$·24 h (40 °C, 90 %) oder weniger beträgt, und das aushärtbare Harz 80 Volumenprozent oder mehr Epoxyharz enthält.

7.  Solarzellenmodul gemäß Anspruch 1, wobei die Wasserdampftransmissionsrate des Rückoberflächenschutzelements 0,02 g/m$^2$·24 h (40 °C, 90 %) oder weniger beträgt, und das aushärtbare Harz 70 Volumenprozent oder mehr Epoxyharz enthält.

8.  Solarzellenmodul gemäß Anspruch 1, wobei das Rückoberflächenschutzelement eine Isolierschicht einschließt, die entweder aus Siliciumoxid oder Metalloxid gebildet ist.

9.  Solarzellenmodul gemäß Anspruch 1, wobei das Rückoberflächenschutzelement Schichten einschließt, die aus Harzmaterialien, aber nicht Metallmaterialien gebildet sind.

10. Solarzellenmodul gemäß Anspruch 1, wobei das Vorderoberflächenelement aus Materialien, die Natrium enthalten, gebildet ist und eine Natriumsperrschicht zum Verhindern von Natriumpermeation zwischen dem Vorderoberflächenelement und dem Solarzellenelement bereitgestellt ist.

11. Solarzellenmodul gemäß Anspruch 1, wobei das Vorderoberflächenelement aus Materialien, die Natrium enthalten, gebildet ist und eine Natriumsperrschicht zum Verhindern von Natriumpermeation auf einer Oberfläche, die an das Vorderoberflächenelement benachbart ist, des Solarzellenelements bereitgestellt ist.

**Revendications**

1.  Module de cellules solaires dans lequel une pluralité d'éléments de cellule solaire sont disposés entre un élément de surface avant et un élément de protection de surface arrière, et les électrodes de collecteur des éléments de cellule solaire sont connectées électriquement les unes aux autres par des languettes de connexion, dans lequel les languettes de connexion sont soudées aux électrodes de collecteur par une soudure en Sn-Ag-Cu, les électrodes de collecteur sont composées d'une pâte électriquement conductrice contenant une résine thermodurcissable et une poudre électriquement conductrice, et la résine thermodurcissable consiste en une résine époxy et une résine d'uréthane, et contient 70 % à 90 % en volume de résine époxy ayant une température de transition vitreuse de 80 °C à 200 °C, la température de transition vitreuse étant mesurée par un procédé d'analyse thermomécanique, TMA.

2. Module de cellules solaires selon la revendication 1, dans lequel la résine époxy a une température de transition vitreuse de 90 °C à 200 °C mesurée par le procédé TMA.

3. Module de cellules solaires selon la revendication 1, dans lequel la poudre électriquement conductrice à mélanger dans la pâte électriquement conductrice comprend un excipient électriquement conducteur approximativement granulé et un excipient électriquement conducteur lamellaire, et une teneur en l'excipient électriquement conducteur approximativement granulé par rapport au poids total des deux excipients conducteurs est de 40 % en poids à 80 % en poids.

4. Module de cellules solaires selon la revendication 1, dans lequel l'élément de protection de surface arrière présente une structure multicouche avec un film mince métallique intercalé entre des couches de résine.

5. Module de cellules solaires selon la revendication 1, dans lequel le débit de transmission de vapeur d'eau de l'élément de protection de surface arrière est de 15 g/m²·24h (40 °C, 90 %) ou moins, et la résine thermodurcissable contient 90 % en volume de résine époxy.

6. Module de cellules solaires selon la revendication 1, dans lequel le débit de transmission de vapeur d'eau de l'élément de protection de surface arrière est de 0,1 g/m²·24h (40 °C, 90 %) ou moins, et la résine thermodurcissable contient 80 % en poids ou plus de résine époxy.

7. Module de cellules solaires selon la revendication 1, dans lequel le débit de transmission de vapeur d'eau de l'élément de protection de surface arrière est de 0,02 g/m²·24h (40 °C, 90 %) ou moins, et la résine thermodurcissable contient 70 % en volume ou plus de résine époxy.

8. Module de cellules solaires selon la revendication 1, dans lequel l'élément de protection de surface arrière comprend une couche d'isolement composée de l'un ou l'autre de l'oxyde de silicium ou d'un oxyde métallique.

9. Module de cellules solaires selon la revendication 1, dans lequel l'élément de protection de surface arrière comprend des couches composées de matériaux résineux, mais pas de matériaux métalliques.

10. Module de cellules solaires selon la revendication 1, dans lequel l'élément de surface avant est composé de matériaux contenant du sodium, et une couche de blocage de sodium pour empêcher la perméation du sodium est prévue entre l'élément de surface avant et l'élément de cellule solaire.

11. Module de cellules solaires selon la revendication 1, dans lequel l'élément de surface avant est composé de matériaux contenant du sodium, et une couche de blocage de sodium pour empêcher la perméation du sodium est prévue sur une surface, qui est adjacente à l'élément de surface avant, de l'élément de cellule solaire.

# Fig.1

# Fig.2

# Fig.3

# Fig.4

## Fig.5

## Fig.6

# Fig.7

# Fig.8

# Fig.9

*Fig.10*

*Fig.11*

# Fig.12

# Fig.13

## Fig.14

## Fig.15

## Fig.16

## Fig.17

# Fig.18

# Fig.19

EP 1 560 272 B1

**Fig.20**

**Fig.21**

40